# EUROPEAN PATENT APPLICATION

(11) **EP 4 832 712 A1**
(43) Date of publication of application: **28.10.2026**
(21) Application number: 26167999.7
(22) Date of filing: 26.03.2026
(51) Int. Cl.: H10K 50/13, H10K 85/30, H10K 85/60, H10K 101/00

(54) **LIGHT-EMITTING ELEMENT, AND ELECTRONIC APPARATUS INCLUDING THE SAME**

(30) Priority: 14.04.2025 KR 20250048357
(71) Applicant: Samsung Display Co., Ltd., Yongin-si, Gyeonggi-do (KR)
(72) Inventor: SYN, Hojung, Yongin-si Gyeonggi-do (KR)
(74) Representative: Gulde & Partner

(57) **Abstract**

A light-emitting element including a first electrode, a light-emitting unit disposed on the first electrode, and a second electrode disposed on the light-emitting unit are provided. The light-emitting unit includes a first emission layer configured to generate light with a first wavelength, a second emission layer configured to generate light with a second wavelength different from the first wavelength on the first emission layer, an intermediate layer on the second emission layer and containing a first compound, and a third emission layer configured to generate light with a third wavelength different from the first and second wavelengths, arranged on the intermediate layer, and containing a second compound, the first compound contains a phosphorescent material, and the second compound contains a fluorescent material.

## Description

### BACKGROUND

### 1. Field

One or more embodiments of the present disclosure described herein relate to a light-emitting element including a plurality of emission layers, and an electronic apparatus including the same.

### 2. Description of the Related Art

An organic light-emitting element is a self-luminous type (kind) of element that exhibits high response speed and operates at a low voltage. Accordingly, because a separate light source may not be required, an organic light-emitting display device including the organic light-emitting element may be lightweight and thin, and may provide advantages such as excellent or suitable luminance and/or wide viewing-angle independence.

An organic light-emitting element is a display element that may include an emission layer including an organic material between an anode electrode and a cathode electrode. Holes provided from the anode electrode and electrons provided from the cathode electrode combine in the emission layer to form excitons, which then generate light corresponding to the energy between the holes and electrons. A plurality of emission layers may be present between the anode electrode and the cathode electrode. The plurality of emission layers may be to emit light with different wavelengths. The light with different wavelengths may be mixed together to emit white color light (e.g., white light).

The information disclosed in this Background section is intended to enhance (facilitate) understanding of the context of the present disclosure and may contain information that does not constitute prior art.

### SUMMARY

The invention is defined by the appended claims. The description that follows is subject to this limitation. Any disclosure lying outside the scope of said claims is only intended for illustrative as well as comparative purposes.

One or more aspects of embodiments of the present invention are directed towards a light-emitting element that has improved display efficiency and display lifespan, and an electronic apparatus including the same.

Additional aspects will be set forth in part in the description which follows and, in part, will be apparent from the description, or may be learned by practice of the presented embodiments of the invention.

According to the present invention, a light-emitting element includes a first electrode, a light-emitting unit arranged on the first electrode, and a second electrode arranged on the light-emitting unit, wherein the light-emitting unit includes a first emission layer configured to generate light with a first wavelength, a second emission layer configured to generate light with a second wavelength different from the first wavelength and arranged on the first emission layer, an intermediate layer arranged on the second emission layer and containing a first compound, and a third emission layer configured to generate light with a third wavelength different from the first and second wavelengths, arranged on the intermediate layer, and containing a second compound, the first compound contains a phosphorescent material, and the second compound contains a fluorescent material.

In one or more embodiments, the second emission layer may be directly arranged on the first emission layer, the intermediate layer may be directly arranged on the second emission layer, and the third emission layer may be directly arranged on the intermediate layer.

In one or more embodiments, the light with the first wavelength may be red color light, the light with the second wavelength may be green color light, and the light with the third wavelength may be blue color light.

In one or more embodiments, the first compound may include a hole-transporting host, an electron-transporting host, and a phosphorescent dopant.

In one or more embodiments, the phosphorescent dopant may be represented by Formula 1.

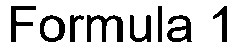

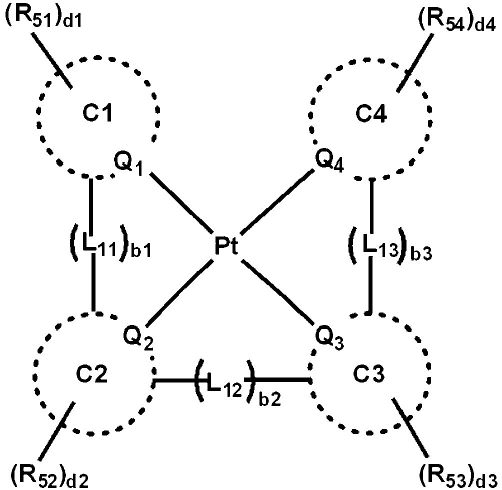

In Formula 1 above, Q1 to Q4 may each independently be C or N, C1 to C4 may each independently be a substituted or unsubstituted hydrocarbon ring having 5 to 30 ring-forming carbon atoms, or a substituted or unsubstituted heterocycle having 2 to 30 ring-forming carbon atoms, L11 to L13 may each independently be a direct linkage, 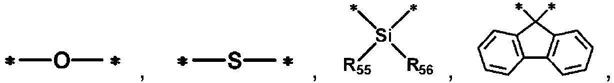 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms, b1 to b3 may each independently be 0 or 1, R51 to R56 may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, or may each be bonded to an adjacent group to form a ring, and d1 to d4 may each independently be an integer of 0 to 4.

In one or more embodiments, the hole-transporting host may include a compound represented by Formula H1.

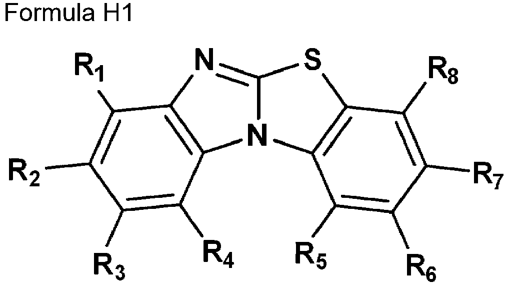

In Formula H1 above, R1 to R8 may each independently be hydrogen, deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may each be optionally bonded to an adjacent group to form a ring.

In one or more embodiments, the electron-transporting host may include a compound represented by Formula ET-1.

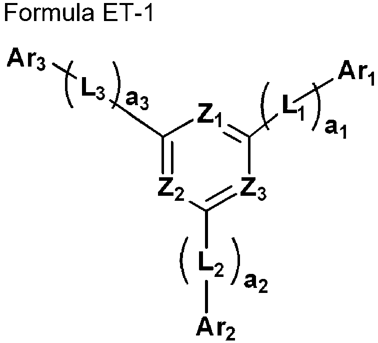

In Formula ET-1 above, at least one among Z1 to Z3 may be N, and the rest are CR9, R9 may be hydrogen, deuterium, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, a1 to a3 may each independently be an integer of 0 to 10, L1 to L3 may each independently be a direct linkage, a substituted or unsubstituted arylene group having 6 to 30 ring-forming carbon atoms, or a substituted or unsubstituted heteroarylene group having 2 to 30 ring-forming carbon atoms, and if (e.g., when) each of a1 to a3 is an integer of 2 or greater, L2 to L4 may each independently be a substituted or unsubstituted arylene group having 6 to 30 ring-forming carbon atoms, or a substituted or unsubstituted heteroarylene group having 2 to 30 ring-forming carbon atoms, and Ar1 to Ar3 may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In one or more embodiments, a weight percentage of the phosphorescent dopant relative to a total weight of the intermediate layer may be about 0.1 % or greater and about 5.0% or less.

In one or more embodiments, the second compound may include a spiro compound.

In one or more embodiments, the first emission layer and the second emission layer may each be a phosphorescent emission layer.

In one or more embodiments, the first emission layer may include a first host and a first dopant, the second emission layer may include a second host and a second dopant, and the first dopant and the second dopant may each independently include a compound represented by Formula D.

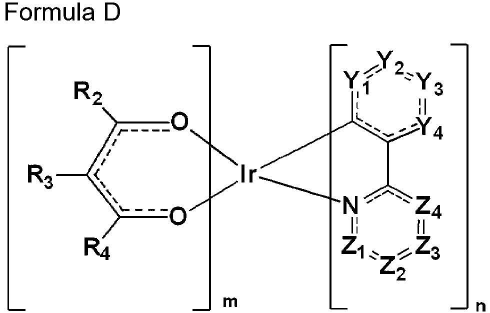

In Formula D above, Y1 to Y4 and Z1 to Z4 may each independently be CR1 or N, R1 to R4 may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may each be optionally bonded to an adjacent group to form a ring, m may be 0 or 1, and n may be 2 or 3.

In one or more embodiments, the light-emitting element may further include a hole transport region arranged between the first electrode and the light-emitting unit, and an electron transport region arranged between the second electrode and the light-emitting unit.

In one or more embodiments, the first emission layer may have a first thickness of about 10 nm or greater and about 30 nm or less, and the second emission layer may have a second thickness of about 1 nm or greater and about 10 nm or less.

In one or more embodiments, a thickness of the intermediate layer may be less than a thickness of the third emission layer.

In one or more embodiments, the thickness of the intermediate layer may be about 1 nm or greater and about 10 nm or less, and the thickness of the third emission layer may be about 5 nm or greater and about 20 nm or less.

According to one or more embodiments of the invention, a light-emitting element includes a first electrode, a light-emitting unit arranged on the first electrode, and a second electrode arranged on the light-emitting unit, and the light-emitting unit includes a first emission layer configured to generate light with a first wavelength, a second emission layer configured to generate light with a second wavelength different from the first wavelength, a third emission layer configured to generate light with a third wavelength different from the first and second wavelengths, and an intermediate layer arranged between the second emission layer and the third emission layer, the intermediate layer includes a hole-transporting host, an electron-transporting host, and a phosphorescent dopant, and a weight percentage of the phosphorescent dopant relative to a total weight of the intermediate layer is about 0.1% or greater and about 5.0% or less.

According to one or more embodiments of the invention, an electronic apparatus includes a display device configured to provide an image, and a power module configured to supply power to the display device, the display device includes a base layer, a circuit layer arranged on the base layer, and a display element layer arranged on the circuit layer and including a light-emitting element, the light-emitting element includes a first electrode, a light-emitting unit arranged on the first electrode, and a second electrode arranged on the light-emitting unit, the light-emitting unit includes a first emission layer configured to generate light with a first wavelength, a second emission layer configured to generate light with a second wavelength different from the first wavelength and arranged on the first emission layer, an intermediate layer arranged on the second emission layer and including a first compound, and a third emission layer configured to generate light with a third wavelength different from the first and second wavelengths, arranged on the intermediate layer, and including a second compound, the first compound includes a phosphorescent material, and the second compound includes a fluorescent material.

In one or more embodiments, the base layer may include a first light-emitting region, a second light-emitting region, and a third light-emitting region which are spaced apart from each other on a plane, and a peripheral region defined between the first to third light-emitting regions, and the first to third emission layers may be provided as common layers for the first to third light-emitting regions.

In one or more embodiments, the electronic apparatus may further include a color filter layer arranged on the display element layer, and the color filter layer may include first to third color filters respectively overlapping the first to third light-emitting regions.

In one or more embodiments, the electronic apparatus may further include a processor and a memory.

For example, one or more embodiments of the present invention provide a light-emitting element and an electronic apparatus that incorporate a multi-layer light-emitting unit configured to improve emission efficiency and operational lifetime. The light-emitting unit includes first and second emission layers that may each be phosphorescent, an intermediate layer containing a hole-transporting host, an electron-transporting host, and a phosphorescent dopant, and a third emission layer that may be fluorescent. By arranging the intermediate layer between the second and third emission layers, residual triplet excitons may be utilized while reducing exciton quenching, thereby enhancing overall device performance. These structural and compositional features, together with optional hole and electron transport regions and specified thickness ranges, enable embodiments to achieve high luminance, low power consumption, and improved reliability in display devices and corresponding electronic apparatuses.

### BRIEF DESCRIPTION OF THE DRAWINGS

The accompanying drawings are included to provide a further understanding of the present invention, and are incorporated in and constitute a part of this disclosure. The drawings illustrate certain embodiments of the present invention and, together with the description, serve to explain principles of the disclosure. Above and/or other aspects of the invention should become apparent and appreciated from the following description of embodiments taken in conjunction with the accompanying drawings. In the drawings:
FIG. 1 is a block diagram of an electronic apparatus according to one or more embodiments;
FIG. 2 illustrates schematic views of an electronic apparatus according to one or more embodiments;
FIG. 3 is an exploded perspective view of an electronic apparatus according to one or more embodiments;
FIG. 4A is a perspective view of an electronic apparatus according to one or more embodiments;
FIG. 4B is an exploded perspective view of the electronic apparatus illustrated in FIG. 4A;
FIG. 5 is a plan view of a display panel according to one or more embodiments;
FIG. 6 is a cross-sectional view of a display panel according to one or more embodiments; and
FIG. 7 is a cross-sectional view schematically illustrating a light-emitting element according to one or more embodiments.

### DETAILED DESCRIPTION

In the present disclosure, if (e.g., when) an element (or a region, a layer, a portion, and/or the like) is referred to as being "on", "connected to" or "coupled to" another element, it may be directly arranged on, connected to, or coupled to the other element, or other elements may be arranged therebetween. In contrast, when an element or layer is referred to as being "directly on," "directly connected to", "directly coupled to", or "immediately adjacent to" another element or layer, there are no intervening elements or layers present.

Like reference numerals or symbols refer to like elements throughout, and duplicative descriptions thereof may not be provided for conciseness. In the drawings, the thickness, ratio, and size of the elements are exaggerated for effectively describing the technical contents. As used herein, the term "and/or" includes any and all combinations of one or more of the associated listed elements.

Although the terms "first", "second", and/or the like may be used herein to describe one or more suitable elements, the elements are not to be limited by these terms. These terms are only used to distinguish one element, component, region, layer or section from another element, component, region, layer or section. For instance, a first element, component, region, layer or section discussed could be termed a second element, component, region, layer or section without departing from the scope of the disclosure. Similarly, a second element, component, region, layer or section could be termed a first element, component, region, layer or section. In the present disclosure, the singular expressions "a", "an" and "the" are intended to include the plural forms as well, unless the context clearly indicates otherwise.

In addition, the terms "below", "under", "on the lower side", "above", "over", "on the upper side", and/or the like may be used to describe the relationships between the elements illustrated in the drawings. These terms are relative concepts and are described on the basis of the directions indicated in the drawings.

It will be further understood that the terms "comprises, includes, has" and/or "comprising, including, having", if (e.g., when) used in this disclosure, specify the presence of stated features, numbers, steps, operations, elements, components and/or combinations thereof, but do not preclude the possibility of the presence or addition of one or more other features, numbers, steps, operations, elements, components, and/or combinations thereof. Additionally, the terms "comprise(s)/comprising," "include(s)/including," "have/has/having", or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the present disclosure, the term "substituted" refers to the replacement on at least one hydrogen by a substituent selected from among the group consisting of deuterium, a halogen, a cyano group, nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group.

In the present disclosure, the term "combining with an adjacent group to form a ring" refers to combining with an adjacent group to form a substituted or unsubstituted hydrocarbon ring, or a substituted or unsubstituted heterocycle. The hydrocarbon ring includes an aliphatic hydrocarbon ring and an aromatic hydrocarbon ring. The heterocycle includes an aliphatic heterocycle and an aromatic heterocycle. The hydrocarbon ring and the heterocycle may be a monocyclic or polycyclic ring. In addition, the ring formed in combination may also be connected to another ring to form a spiro structure.

In the present disclosure, the term "adjacent group" refers to a substituent substituted for an atom directly connected to an atom substituted with the corresponding substituent, another substituent substituted for the atom substituted with the corresponding substituent, or a substituent most adjacent to the corresponding substituent three-dimensionally. For example, two methyl groups in 1,2-dimethylbenzene may be interpreted as the "adjacent groups" to each other, and two ethyl groups in 1,1-diethylcyclopentane may be interpreted as the "adjacent groups" to each other. In addition, two methyl groups in 4,5-dimethylphenanthrene may be interpreted as the "adjacent groups" to each other.

In the present disclosure, examples of a halogen atom include a fluorine atom, a chlorine atom, a bromine atom, and/or an iodine atom.

In this specification, an alkyl group may be linear or branched. The alkyl group has 1 to 60, 1 to 30, 1 to 20, 1 to 10, or 1 to 6 carbon atoms. Examples of the alkyl group may include a methyl group, an ethyl group, an n-propyl group, an isopropyl group, an n-butyl group, an s-butyl group, a t-butyl group, an i-butyl group, a 2-ethylbutyl group, 3, 3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldodecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-icosyl group, a 2-ethylicosyl group, a 2-butylicosyl group, a 2-hexylicosyl group, a 2-octylicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, and an n-triacontyl group, but the example is not limited thereto.

In the present disclosure, a cycloalkyl group may refer to a cyclic alkyl group. The cycloalkyl group has 3 to 60, 3 to 30, or 3 to 20, 3 to 10 carbon atoms. Examples of the cycloalkyl group includes a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, 2-adamantyl group, an isobornyl group, bicycloheptyl group, and/or the like, but the example is not limited thereto.

In the present disclosure, an alkenyl group refers to a hydrocarbon group containing one or more carbon double bonds in the middle or at the end of the alkyl group having 2 or more carbon atoms. The alkenyl group may be linear or branched. The alkenyl group has 2 to 60, 2 to 30, 2 to 20, or 2 to 10 carbon atoms, but the number of carbon atoms is not particularly limited. Examples of the alkenyl group includes a vinyl group, a 1-butenyl group, a 1-pentenyl group, a 1,3-butadienyl aryl group, a styrenyl group, a styryl vinyl group, and/or the like, but the example is not limited thereto.

In the present disclosure, an alkynyl group refers to a hydrocarbon group containing one or more carbon triple bonds in the middle or at the end of the alkyl group having 2 or more carbon atoms. The alkynyl group may be linear or branched. The alkynyl group has 2 to 30, 2 to 20, or 2 to 10 carbon atoms, but the number of carbon atoms is not particularly limited. Examples of the alkynyl group may include an ethynyl group, propynyl group, and/or the like, but the example is not limited thereto.

In the present disclosure, a hydrocarbon ring group refers to any functional group or substituent derived from an aliphatic hydrocarbon ring. The hydrocarbon ring group may be a saturated hydrocarbon ring group having 5 to 20 ring-forming carbon atoms.

In the present disclosure, an aryl group refers to any functional group or any substituent derived from an aromatic hydrocarbon ring. The aryl group may be a monocyclic aryl group or a polycyclic aryl group. The aryl group may have 6 to 60, 6 to 30, 6 to 20, or 6 to 15 ring-forming carbon atoms. Examples of the aryl group include a phenyl group, a naphthyl group, a fluorenyl group, an anthracenyl group, a phenanthryl group, a biphenyl group, a terphenyl group, a quaterphenyl group, a quinquephenyl group, a sexyphenyl group, a triphenylenyl group, a pyrenyl group, a benzo fluoranthenyl group, a chrysenyl group, and/or the like, but the example is not limited thereto.

In the present disclosure, the fluorenyl group may be substituted, and two substituents may also be bonded to form a spiro structure. The example of the substituted fluorenyl group is as follows. However, the example is not limited thereto.

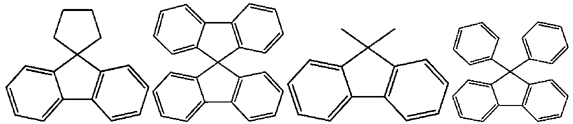

In the present disclosure, a heterocyclic group refers to any functional group or substituent derived from a ring containing one or more of B, O, N, P, S, Si, and Se as a hetero atom. The heterocyclic group includes an aliphatic heterocyclic group and an aromatic heterocyclic group. The aromatic heterocyclic group may be a heteroaryl group. The aliphatic heterocycle and the aromatic heterocycle may be a monocyclic or polycyclic ring.

In the present disclosure, the heterocyclic group may include one or more of B, O, N, P, S, Si, and Se as a hetero atom. When the heterocyclic group includes two or more hetero atoms, the two or more hetero atoms may be the same, or different from each other. The heterocyclic group may be a monocyclic heterocyclic group, or a polycyclic heterocyclic group, which refers to including a heteroaryl group. The heterocyclic group may have 2 to 60, 2 to 30, 2 to 20, or 2 to 10 ring-forming carbon atoms.

In the present disclosure, the aliphatic heterocyclic group may include one or more of B, O, N, P, S, Si, and Se, as a hetero atom. The aliphatic heterocyclic group may have 2 to 30, 2 to 20, or 2 to 10 ring-forming carbon atoms. Examples of the aliphatic heterocyclic group includes an oxirane group, a thiirane group, a pyrrolidine group, a piperidine group, a tetrahydrofuran group, a tetrahydrothiophene group, a thiane group, a tetrahydropyran group, a 1,4-dioxolane group, and/or the like, but the example is not limited thereto.

In the present disclosure, the heteroaryl group may include one or more of B, O, N, P, S, Si, and Se as a hetero atom. When the heteroaryl group includes two or more hetero atoms, the two or more hetero atoms may be the same, or different from each other. The heteroaryl group may be a monocyclic heterocyclic group or a polycyclic heterocyclic group. The heteroaryl group may have 2 to 60, 2 to 30, 2 to 20, or 2 to 10 ring-forming carbon atoms. Examples of the heteroaryl group includes a thiophene group, a furan group, a pyrrole group, an imidazole group, a pyridine group, bipyridine group, a pyrimidine group, a triazine group, a triazole group, an acridyl group, a pyridazine group, a pyrazinyl group, a quinoline group, quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-aryl carbazole group, an N-heteroaryl carbazole group, an N-alkyl carbazole group, a benzooxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, dibenzosilole group, a dibenzofuran group, and/or the like, but the example is not limited thereto.

In the present disclosure, the description on the aryl group previously described may be applied to an arylene group, except that the arylene group is a divalent group. The description on the heteroaryl group previously described may be applied to an heteroarylene group, except that the heteroarylene group is a divalent group.

In the present disclosure, a silyl group includes an alkyl silyl group and an aryl silyl group. Examples of the silyl group includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, but the example is not limited thereto.

In the present disclosure, a carbonyl group may have 1 to 40, 1 to 30, or 1 to 20 carbon atoms, but the number of carbon atoms is not limited thereto. For example, the carbonyl group may have a structure, but the present disclosure is not limited thereto.

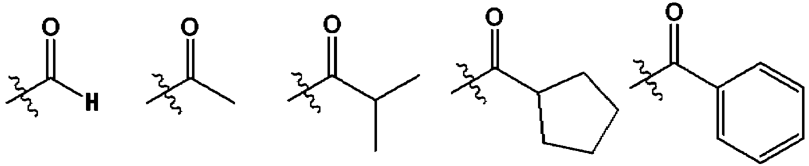

In the present disclosure, a sulfinyl group and a sulfonyl group may have 1 to 30 carbon atoms, but the number of carbon atoms is not limited thereto. The sulfinyl group may include an alkyl sulfinyl group and an aryl sulfinyl group. The sulfonyl group may include an alkyl sulfonyl group and an aryl sulfonyl group.

In the present disclosure, a thio group may include an alkyl thio group and an aryl thio group. The thio group may refer to that a sulfur atom is bonded to the alkyl group or aryl group defined as above. Examples of the thio group include a methylthio group, an ethylthio group, a propylthio group, a pentylthio group, a hexylthio group, an octylthio group, a dodecylthio group, cyclopentylthio group, a cyclohexylthio group, a phenylthio group, a naphthylthio group, and/or the like, but the example is not limited thereto.

In the present disclosure, an oxy group may refer to that an oxygen atom is bonded to the alkyl group or aryl group defined as above. The oxy group may include an alkoxy group and an aryl oxy group. The alkoxy group may be a linear, branched, or cyclic chain. The alkoxy group may have, for example, 1 to 20 or 1 to 10 carbon atoms, but the number of carbon atoms is not limited thereto. Examples of the oxy group includes methoxy, ethoxy, n-propoxy, isopropoxy, butoxy, pentyloxy, hexyloxy, octyloxy, nonyloxy, decyloxy, benzyloxy, and/or the like, but the example is not limited thereto.

In the present disclosure, a boron group may refer to that a boron atom is bonded to the alkyl group or aryl group defined as above. The boron group includes an alkyl boron group and an aryl boron group. Examples of the boron group include a dimethylboron group, a diethylboron group, a t-butylmethylboron group, a diphenylboron group, a phenylboron group, and/or the like, but the example is not limited thereto.

In the present disclosure, an amine group may have 1 to 30 carbon atoms, but the number of carbon atoms is not limited thereto. The amine group may include an alkyl amine group and an aryl amine group. Examples of the amine group include a methylamine group, a dimethylamine group, a phenylamine group, a diphenylamine group, a naphthylamine group, a 9-methyl-anthracenylamine group, and/or the like, but the example is not limited thereto.

In the present disclosure, an alkyl group, an alkylthio group, an alkylsulfoxy group, an alkylaryl group, an alkylamino group, an alkylboron group, an alkylsilyl group, and an alkylamine group, includes the same examples of the alkyl group previously described.

In the present disclosure, an aryl group, an aryloxy group, an arylthio group, an arylsulfoxy group, an arylamino group, an arylboron group, an arylsilyl group, and an arylamine group, includes the same examples of the aryl group previously described.

In the present disclosure, a direct linkage may refer to a single bond.

In the present disclosure, " 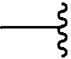 " and " 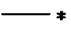 " refer to a position to be connected.

Hereinafter, one or more embodiments of the disclosure will be described with reference to the accompanying drawings.

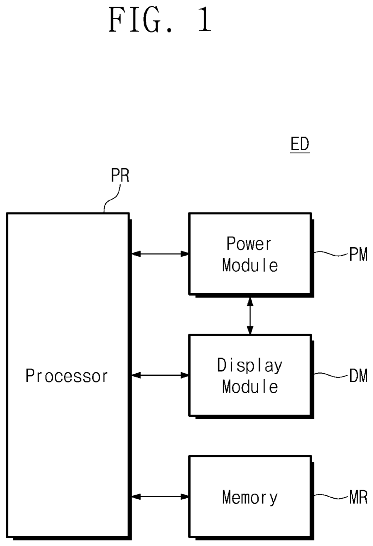

FIG. 1 is a block diagram of an electronic apparatus according to one or more embodiments. Referring to FIG. 1, an electronic apparatus ED according to one or more embodiments may include a display module DM, a processor PR, a memory MR, and a power module PM.

The processor PR may include at least one selected from among a central processing unit (CPU), an application processor (AP), a graphic processing unit (GPU), a communication processor (CP), an image signal processor (ISP), or a controller.

In the memory MR, data information necessary for operation of the processor PR and/or the display module DM may be stored. When the processor PR runs an application stored in the memory MR, image data signals and/or input control signals may be transmitted to the display module DM, and the display module DM may process the received signals to output image information through a display screen. The display module DM may include a display panel displaying an image.

The power module PM may include a power supply module such as a power adapter or a battery device, and a power-converting module that converts power supplied by the power supply module and generates power necessary for operation of the electronic apparatus ED.

At least one among the components of the electronic apparatus ED, previously described, may be included in a display module according to one or more embodiments to be described later, and in a display device according to one or more embodiments including the same. In addition, some individual modules, included in one functional module, may be included in the display device and others may also be provided separately from the display device. For example, the display device may include the display module DM, and the processor PR, the memory MR, and the power module PM may be provided in the form of a device other than the display device in the electronic apparatus ED.

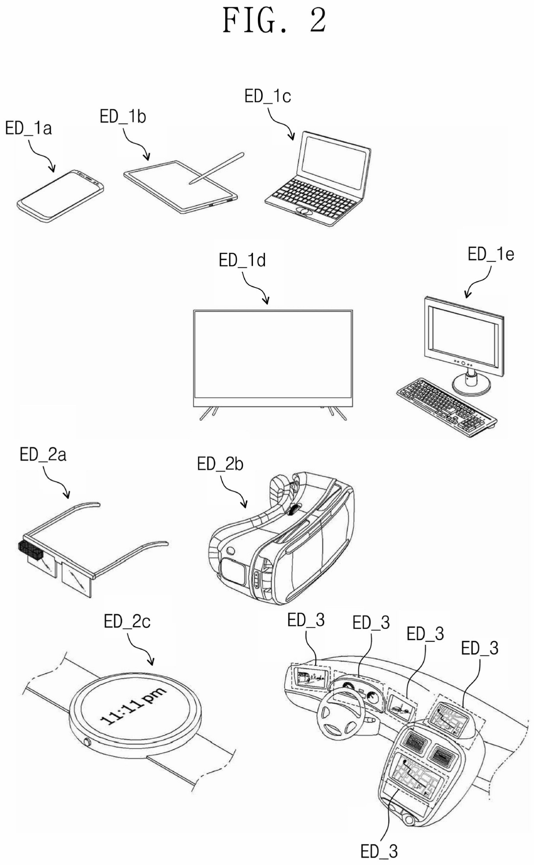

FIG. 2 illustrates schematic views of one or more suitable embodiments of the electronic apparatus ED.

Referring to FIG. 2, one or more suitable electronic apparatuses including a display module according to one or more embodiments may not only include electronic apparatuses for displaying images such as a smartphone ED_1a, a tablet PC ED_1b, a laptop computer ED_1c, a TV ED_1d, and a desktop monitor ED_1e, but also include wearable electronic apparatuses such as smart glasses ED_2a, a head mounted display ED_2b, and a smart watch ED_2c, electronic apparatuses for vehicles ED_3 such as a car dashboard, a center fascia, a center information display (CID) arranged on the dashboard, and a room mirror display, and/or the like.

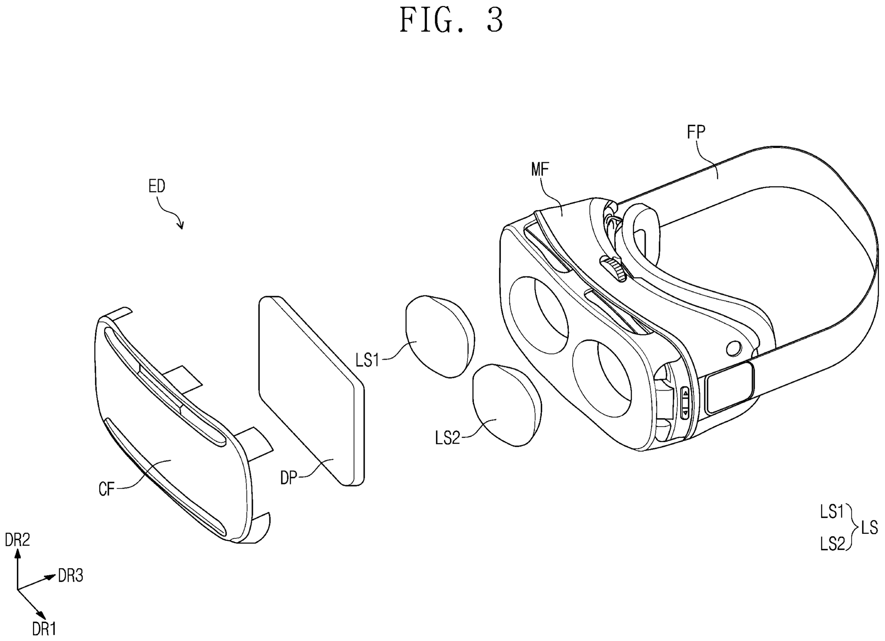

FIG. 3 is an exploded perspective view illustrating an electronic apparatus ED according to one or more embodiments.

FIG. 3 illustrates a head mounted display device as an example of the wearable electronic apparatus such as smart glasses ED_2a, a head mounted display ED_2b, and a smart watch ED_2c previously described with reference to FIG. 2. The head mounted display device may be a device that is mounted on the head of a user to provide a screen displaying a video or image to the user. The head mounted display device may have a see-through type (kind) providing augmented reality (AR) on the basis of actual objects in the outside, and a see-closed type (kind) providing virtual reality (VR) to a user through a screen independently of the objects in the outside.

Referring to FIG. 3, the electronic apparatus ED may include a display panel DP, and a lens part LS opposed to the display panel DP. In addition, the electronic apparatus ED may include a main frame MF, a cover frame CF, and a fixing part FP.

The main frame MF may be a portion to be worn on a face of a user. The main frame MF may have a shape corresponding to the shape of head (face) of the user. For example, the length of the fixing part FP may be adjusted according to the perimeter of the head of the user. The fixing part FP may be a structure that facilitates installation of the main frame MF, which may include a strap, a belt, and/or the like. However, embodiments are not limited thereto, and the fixing part FP may have one or more suitable forms including a helmet or eyeglass temples to be coupled to the main frame MF.

The lens part LS, the display panel DP, and the cover frame CF may be mounted on the main frame MF. The main frame MF may include a space or structure capable of accommodating the lens part LS and the display panel DP.

The lens part LS may be arranged between the display panel DP and a user. The lens part LS may provide the user with light emitted from the display panel DP by passing the light through the lens. For example, the lens part LS may include one or more suitable types (kinds) of lenses such as a multichannel lens, a convex lens, a concave lens, a spherical lens, an aspherical lens, a single lens, a compound lens, a standard lens, a narrow-angle lens, a wide-angle lens, a fixed focus lens, and/or a variable focus lens.

The lens part LS may include a first lens LS1 and a second lens LS2. The first lens LS1 and the second lens LS2 may be arranged corresponding to respective positions of left eye and right eye of the user. The first lens LS1 and the second lens LS2 may be accommodated in the main frame MF. The display panel DP may be provided in a state of being fixed on the main frame MF, and may also be provided in a removable state.

The cover frame CF may be arranged on one surface of the display panel DP to protect the display panel DP. The cover frame CF and the lens part LS may be spaced apart from each other with the display panel DP therebetween.

In FIG. 3 and the following drawings, a first directional axis DR1 to a third directional axis DR3 are illustrated, and directions indicated by the first to third directional axes DR1, DR2, and DR3, described in the present disclosure, may be relative concepts, and may be changed to other directions. In addition, the directions indicated by the first to third directional axes DR1, DR2, and DR3 may be described as first to third directions, and may be denoted as the same reference numerals or symbols. In the present disclosure, the first directional axis DR1 and the second directional axis DR2 may cross each other, and the third directional axis DR3 may be a normal direction of a plane defined by the first directional axis DR1 and the second directional axis DR2.

A thickness direction of the electronic apparatus ED may be a direction parallel to the third directional axis DR3 that is the normal direction of the plane defined by the first directional axis DR1 and the second directional axis DR2. In the present disclosure, a front surface (or upper surface) and a rear surface (or lower surface) of each of members constituting the electronic apparatus ED may be defined on the basis of the third directional axis DR3. In the present disclosure, the term "on a plane" refers to a surface parallel to the plane defined by the first directional axis DR1 and the second directional axis DR2, and the term "on cross-section" refers to a surface parallel to the third directional axis DR3.

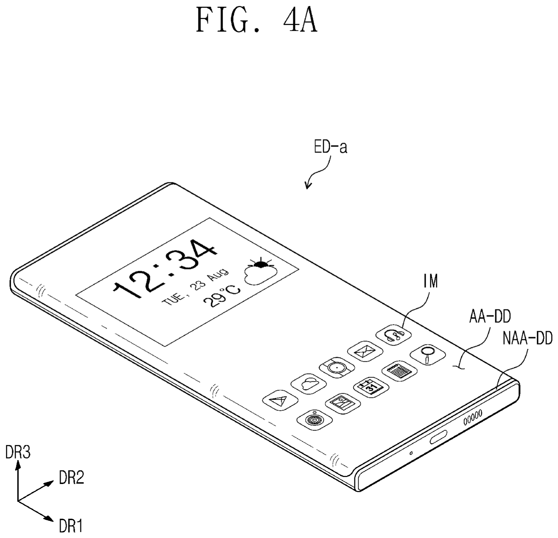

FIG. 4A is a perspective view of an electronic apparatus ED according to one or more embodiments. FIG. 4A illustrates a mobile phone as an example of the electronic apparatus for displaying images such as a smartphone ED_1a, a tablet PC ED_1b, a laptop computer ED_1c, a TV ED_1d, and a desktop monitor ED_1e as previously described in FIG. 2.

An electronic apparatus ED-a may display an image IM through an active region AA-DD. The active region AA-DD may include a flat surface defined by the first directional axis DR1 and the second directional axis DR2. The active region AA-DD may include a curved surface bent from at least one side of the flat surface defined by the first directional axis DR1 and the second directional axis DR2. However, this is an example, and the shape of the active region AA-DD is not limited thereto. For example, the active region AA-DD may include only the flat surface, and may further include curved surfaces bent from at least two sides of the flat surface, for example, may include four curved surfaces respectively bent from four sides of the flat surface.

A peripheral region NAA-DD is adjacent to the active region AA-DD. The peripheral region NAA-DD may be around (e.g., may surround) the active region AA-DD. Accordingly, a shape of the active region AA-DD may be defined substantially by the peripheral region NAA-DD. However, this is illustrated as an example, and the peripheral region NAA-DD may also be arranged adjacent to only one side of the active region AA-DD, and may also not be provided. The active region AA-DD may be provided in one or more suitable shapes, and is not limited to any one of the embodiments.

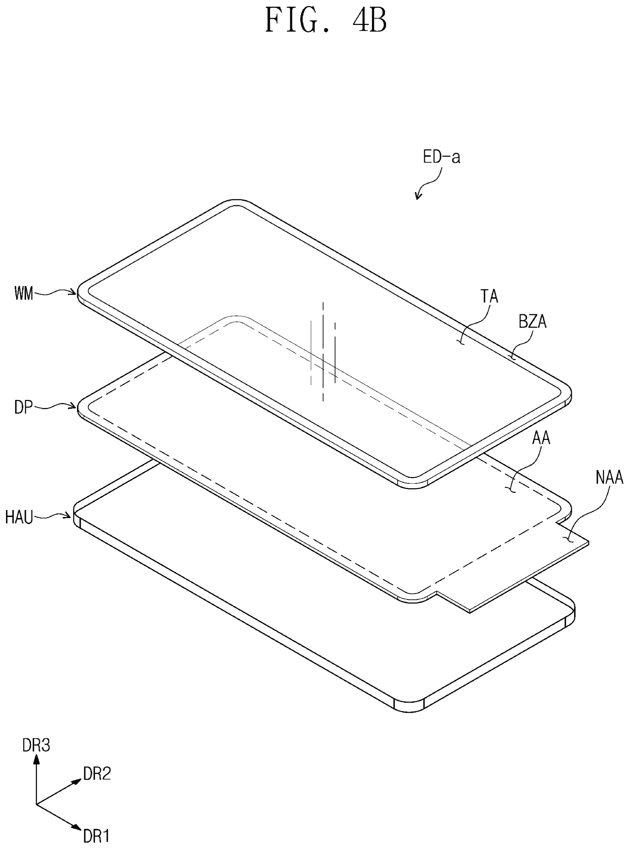

FIG. 4B is an exploded perspective view of the electronic apparatus ED-a illustrated in FIG. 4A. Referring to FIG. 4B, the electronic apparatus ED-a may include a housing HAU, a display panel DP, and a window member WM.

The window member WM may cover the entire outer side of the display panel DP. The window member WM may include a transmission region TA and a bezel region BZA. A front surface of the window member WM, including the transmission region TA and the bezel region BZA, may correspond to a front surface of the electronic apparatus ED-a. The transmission region TA may correspond to the active region AA-DD of the electronic apparatus ED-a illustrated in FIG. 4A, and the bezel region BZA may correspond to the peripheral region NAA-DD of the electronic apparatus ED-a illustrated in FIG. 4A.

The transmission region TA may be an optically transparent region. The bezel region BZA may be a region which is relatively low in light transmittance, compared to the transmission region TA. The bezel region BZA may have a color. The bezel region BZA may be adjacent to the transmission region TA, and may be around (e.g., may surround) the transmission region TA. The bezel region BZA may define the shape of the transmission region TA. However, embodiments are not limited to what is illustrated in the drawing, and the bezel region BZA may also be arranged adjacent only to one side of the transmission region TA, and a portion of the bezel region BZA may also not be provided.

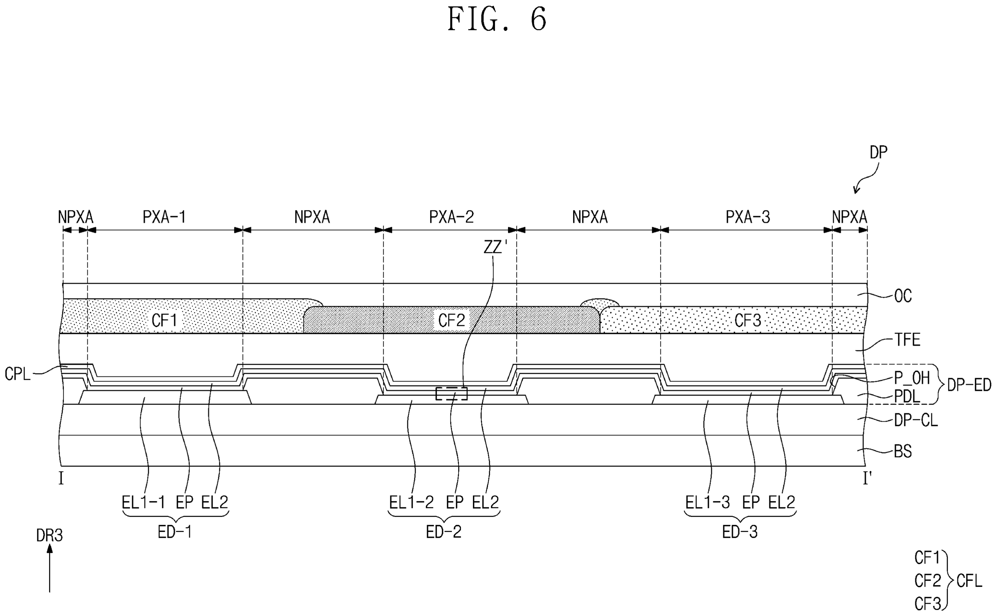

In one or more embodiments, an input-sensing part may be provided onto the display panel DP. The input-sensing part may detect an external input applied from the outside. The external input may be a user's input. The user's input may include one or more suitable types (kinds) of external inputs such as a part of the user's body, light, heat, a pen, and/or pressure. More particularly, the input-sensing part may be arranged on an encapsulation layer TFE (see FIG. 6) of the display panel DP. In one or more embodiments, the input-sensing part may be directly arranged on the encapsulation layer TFE (see FIG. 6), or may be directly arranged on an adhesion member arranged on the encapsulation layer TFE (see FIG. 6). The adhesion member may include a general adhesive or sticking agent.

In the present disclosure, if (e.g., when) it is mentioned that a component (or region, layer, section, and/or the like) is "directly arranged" on another component, it refers to that no third component is arranged between the component and the other component. For example, one component "directly arranged" on another component refers to that the one and the other components are "in contact with" each other.

The housing HAU may accommodate the display panel DP, and/or the like. The housing HAU may be coupled to the window member WM.

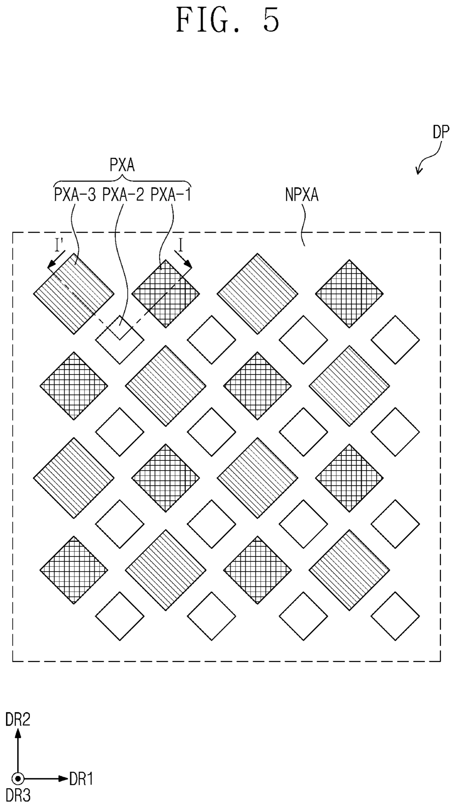

FIG. 5 is a plan view illustrating a display panel DP according to one or more embodiments. Hereinafter, description on the display panel DP may be equally applied to the display panel DP included in the electronic apparatus ED illustrated in FIGS. 2, 3, and 4A.

Referring to FIG. 5, the display panel DP may include a light-emitting region PXA and a non-light-emitting region NPXA. The non-light-emitting region NPXA may be around (e.g., may surround) the light-emitting region PXA. The light-emitting region PXA may be provided in plurality. The light-emitting region PXA may include a first light-emitting region PXA-1, a second light-emitting region PXA-2, and a third light-emitting region PXA-3. The first light-emitting region PXA-1, the second light-emitting region PXA-2, and the third light-emitting region PXA-3 may each emit light with different wavelengths. The first light-emitting region PXA-1 may be to emit first light, and the second light-emitting region PXA-2 may be to emit second light different from the first light. The third light-emitting region PXA-3 may be to emit third light different from the first light and second light.

Among the first to third light-emitting regions PXA-1, PXA-2, and PXA-3, the third light-emitting region PXA-3 may have the largest area, and the second light-emitting region PXA-2 may have the smallest area. However, this is an example, and the areas of the first to third light-emitting regions PXA-1, PXA-2, and PXA-3 are not limited thereto. FIG. 5 illustrates that the first light-emitting region PXA-1 and the third light-emitting region PXA-3 are alternately arranged on one row, and the second light-emitting region PXA-2 is spaced apart from the first light-emitting region PXA-1 and the third light-emitting region PXA-3 and arranged on another row. However, this is an example, and the arrangement of the first to third light-emitting regions PXA-1, PXA-2, and PXA-3 is not limited thereto.

FIG. 6 is a cross-sectional view of a display panel according to one or more embodiments. FIG. 6 is a cross-sectional view illustrating a portion taken along the line I-I' of FIG. 5. FIG. 6 illustrates components included in the display panel DP in more detail.

Referring to FIG. 6, the display panel DP may include a base layer BS, a circuit layer DP-CL arranged on the base layer BS, a display element layer DP-ED arranged on the circuit layer DP-CL, an encapsulation layer TFE arranged on the display element layer DP-ED, and a color filter layer CFL arranged on the encapsulation layer TFE.

The base layer BS may be a member that provides a base surface where the circuit layer DP-CL is arranged. The base layer BS may be a rigid substrate, or a flexible substrate capable of bending, folding, rolling, and/or the like. The base layer BS may be a glass substrate, a metal substrate, a polymer substrate, and/or the like. However, embodiments are not limited thereto, and the base layer BS may be an inorganic layer, an organic layer, or a composite material layer.

The base layer BS may have a single-layer or multi-layer structure. For example, the base layer BS may include a first synthetic resin layer, an intermediate layer in a multi-layer or single-layer structure, and a second synthetic resin layer that are stacked in sequence. The intermediate layer may be referred to as a base barrier layer. The intermediate layer may include a silicon oxide (SiOx) layer and an amorphous silicon (a-Si) layer arranged on the silicon oxide layer, but is not limited thereto. For example, the intermediate layer may a silicon oxide layer, a silicon nitride layer, a silicon oxynitride layer, and/or an amorphous silicon layer.

The first and second synthetic resin layers may each include a polyimide-based resin. In addition, the first and second synthetic resin layers may each include at least one of an acrylate-based resin, a methacrylate-based resin, a polyisoprene-based resin, a vinyl-based resin, an epoxy-based resin, a urethane-based resin, a cellulose-based resin, siloxane-based resin, a polyamide-based resin, or a perylene-based resin. In this specification, "~~"-based resin refers to including the functional group of "~~".

The circuit layer DP-CL may be arranged on the base layer BS. The circuit layer DP-CL may include an insulation layer, a semiconductor pattern, a conductive pattern, a signal line, and/or the like. An insulation layer, a semiconductor layer, and a conductive layer may be formed on the base layer BS through coating, deposition, and/or the like, and then, the insulation layer, the semiconductor layer, and the conductive layer may be patterned (e.g., selectively patterned) through multiple cycles of photolithography processes. After this, the semiconductor pattern, the conductive pattern, and the signal lines included in the circuit layer DP-CL may be formed.

The display element layer DP-ED may be arranged on the circuit layer DP-CL. The display element layer DP-ED may include first to third light-emitting elements ED-1, ED-2, and ED-3 and a pixel-defining film PDL. Referring to FIG. 6, the first to third light-emitting elements ED-1, ED-2, and ED-3 may be spaced apart from each other in one direction perpendicular to a thickness direction DR3.

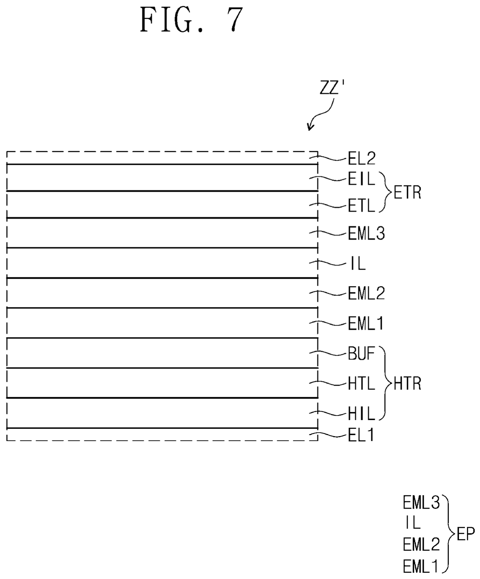

Each of the first to third light-emitting elements ED-1, ED-2, and ED-3 includes a first electrode EL1-1, EL1-2, and EL1-3, a light-emitting unit EP arranged on the first electrode EL1-1, EL1-2, and EL1-3, and a second electrode EL2 arranged on the light-emitting unit EP. In addition, each of the first to third light-emitting elements ED-1, ED-2, and ED-3 may further include a capping layer CPL. The light-emitting unit EP may include a plurality of emission layers EML-1, EML-2, and EML-3 (see FIG. 7) emitting light with different wavelengths. The light-emitting unit EP will be described in more detail later.

In the first to third light-emitting elements ED-1, ED-2, and ED-3, the light-emitting unit EP may overlap first to third light-emitting regions PXA-1, PXA-2, and PXA-3 and a non-light-emitting region NPXA. The light-emitting unit EP may be provided as a common layer for the first to third light-emitting regions PXA-1, PXA-2, and PXA-3. In present disclosure, the "common layer" may refer to being provided in common throughout the entire light-emitting elements ED-1, ED-2, and ED-3, and substantially forming one component. In addition, in the first to third light-emitting elements ED-1, ED-2, and ED-3, a hole transport region HTR (see FIG. 7) and an electron transport region ETR (see FIG. 7) may be provided as common layers. In the first to third light-emitting elements ED-1, ED-2, and ED-3, the second electrode EL2 may be provided as a common electrode. In the present disclosure, one component overlapping another component is not limited to having the same area and same shape on a plane, and also includes having different areas and/or different shapes.

A pixel opening P_OH of the pixel-defining film PDL may expose at least a portion of the first electrode EL1-1, EL1-2, and EL1-3. The first to third light-emitting regions PXA-1, PXA-2, and PXA-3 may be defined corresponding to the first electrodes EL1-1, EL1-3, and EL1-3 exposed by the pixel opening P_OH, respectively. The non-light-emitting region NPXA may be a region corresponding to the pixel-defining film PDL.

The encapsulation layer TFE may be arranged on the display element layer DP-ED. The encapsulation layer TFE may protect the display element layer DP-ED from moisture, oxygen, and foreign substance, such as dust particles and/or the like. The encapsulation layer TFE may include at least one inorganic film (hereinafter, inorganic encapsulation film). In addition, the encapsulation layer TFE may include at least one organic film (hereinafter, organic encapsulation film) and at least one inorganic encapsulation film.

The inorganic encapsulation film may protect the display element layer DP-ED from moisture, oxygen, and the organic encapsulation film may protect the display element layer DP-ED from foreign substances, such as dust particles and/or the like. The inorganic encapsulation film may include silicon nitride, silicon oxynitride, silicon oxide, titanium oxide, aluminum oxide, and/or the like, and is not limited thereto. The organic encapsulation film may include an acrylate-based compound, an epoxy-based compound, and/or the like. The organic encapsulation film may include an organic material capable of photopolymerization, and is not limited thereto.

The color filter layer CFL may be arranged on the encapsulation layer TFE. The color filter layer CFL may include a first filter CF1 corresponding to the first light-emitting region PXA-1, a second filter CF2 corresponding to the second light-emitting region PXA-2, and a third filter CF3 corresponding to the third light-emitting region PXA-3. The color filter layer CFL may include the first filter CF1 transmitting first light, the second filter CF2 transmitting second light, and the third filter CF3 transmitting third light. For example, the first filter CF1 may be a red color filter, the second filter CF2 may be a green color filter, and the third filter CF3 may be a blue color filter. The first to third filters CF1, CF2, and CF3 may each include a polymer photosensitive resin and a colorant. In the present disclosure, the colorant may include a pigment and/or a dye. The first filter CF1 may include a red pigment or a red dye, the second filter CF2 may include a green pigment or a green dye, and the third filter CF3 may include a blue pigment or a blue dye.

The color filter layer CFL may further include a light-blocking part corresponding to the non-light-emitting region NPXA. The light-blocking part may be a black matrix. The light-blocking part may be formed by including an organic light-blocking material or an inorganic light-blocking material containing a black pigment or a black dye. The light-blocking part may prevent or reduce a light-leak phenomenon, and may set boundaries between the filters CF1, CF2, and CF3 adjacent to each other.

An overcoat layer OC may be arranged on the color filter layer CFL. The overcoat layer OC may cover the first to third filter parts CF1, CF2, and CF3. The overcoat layer OC may overlap the entire display element layer DP-ED. An upper surface of the overcoat layer OC may cover the entire surface of the display panel DP to protect the display panel DP.

FIG. 7 is a cross-sectional view schematically illustrating a light-emitting element according to one or more embodiments. FIG. 7 is an enlarged cross-sectional view illustrating a ZZ' region of FIG. 6.

Referring to FIG. 7, the light-emitting element ED-2 (see FIG. 6) may include a first electrode EL1, a hole transport region HTR arranged on the first electrode EL1, a light-emitting unit EP arranged on the hole transport region HTR, an electron transport region ETR arranged on the light-emitting unit EP, and a second electrode EL2 arranged on the electron transport region ETR. FIG. 7 particularly illustrates an enlarged view of the second light-emitting element ED-2 among the first to third light-emitting elements ED-1, ED-2, and ED-3 illustrated in FIG. 6, but this is illustrated for the convenience of description, and the description may be applied equally to the first and third light-emitting elements ED-1 and ED-3. In addition, the first electrode EL1-2 included in the second light-emitting element ED-2, illustrated in FIG. 6, is illustrated as a first electrode EL1 in FIG. 7 for the convenience, and hereinafter described as the first electrode EL1.

The first electrode EL1 has conductivity (e.g., is a conductor). The first electrode EL1 may include a metal material, a metal alloy, and/or a conductive compound. The first electrode EL1 may be an anode or a cathode. However, embodiments are not limited thereto. In addition, the first electrode EL1 may be a pixel electrode. The first electrode EL1 may be a transmissive electrode, a transflective electrode, and/or a reflective electrode. The first electrode EL1 may include at least one selected from among Ag, Mg, Cu, Al, Pt, Pd, Au, Ni, Nd, Ir, Cr, Li, Ca, LiF, Mo, Ti, W, In, Sn, and Zn, a compound of two or more selected therefrom, a mixture of two or more selected therefrom, or an oxide thereof.

When the first electrode EL1 is a transflective electrode or reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, or a compound thereof or a mixture thereof (for example, a mixture of Ag and Mg). In one or more embodiments, the first electrode EL1 may have a multi-layer structure including a reflective film or transflective film including the above-mentioned materials, and a transparent conductive film including indium tin oxide (ITO), indium zinc oxide (IZO), zinc oxide (ZnO), indium tin zinc oxide (ITZO), and/or the like. For example, the first electrode EL1 may be a reflective electrode, and include a transparent conductive oxide (TCO). The first electrode EL1 may have a three-layer structure of ITO/Ag/ITO, but embodiments are not limited thereto.

The hole transport region HTR may be provided onto the first electrode EL1. The hole transport region HTR may include a hole injection layer HIL, a hole transport layer HTL, and a buffer layer BUF. The buffer layer BUF may compensate for resonance distance according to the wavelength of light emitted from the light-emitting unit EP, and control hole charge balance to thereby increase light-emitting efficiency. In addition, the buffer layer BUF may also serve to prevent or reduce electron injection into the hole transport layer HTL.

Contrary to what is illustrated in FIG. 7, the hole transport region HTR may have a single-layer structure including a plurality of different materials, or may have a structure of a hole injection layer HIL/hole transport layer HTL, a hole injection layer HIL/hole transport layer HTL/light-emitting auxiliary layer, a hole injection layer HIL/light-emitting auxiliary layer, a hole transport layer HTL/light-emitting auxiliary layer, a hole injection layer HIL/hole transport layer HTL/light-emitting auxiliary layer, or a hole injection layer HIL/hole transport layer HTL/ electron-blocking layer, sequentially stacked from the first electrode EL1, but embodiments are not limited thereto.

The hole transport region HTR may be formed using one or more suitable methods including vacuum deposition, spin coating, casting, Langmuir-Blodgett (LB), inkjet printing, laser printing, laser induced thermal imaging (LITI), and/or the like.

The hole transport region HTR may include a compound represented by Formula H-1.

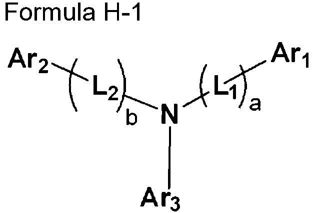

In Formula H-1 above, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. a and b may each independently be an integer of 0 to 10. When a or b is an integer of 2 or greater, L₁ and L₂ in plurality may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. In addition, in Formula H-1, Ar₃ may be a substituted or unsubstituted aryl group having 6 to 30 ring-forming carbon atoms.

The compound represented by Formula H-1 above may be a monoamine compound. In one or more embodiments, the compound represented by Formula H-1 above may be a diamine compound in which at least one among Ar₁ to Ar₃ contains an amine group as a substituent. In addition, the compound represented by Formula H-1 above may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be represented by any one among (e.g., any one selected from among) the compounds of Compound Group H. However, the compounds listed in Compound Group H are examples, and the compound represented by Formula H-1 is not limited to those listed in Compound Group H.

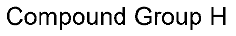

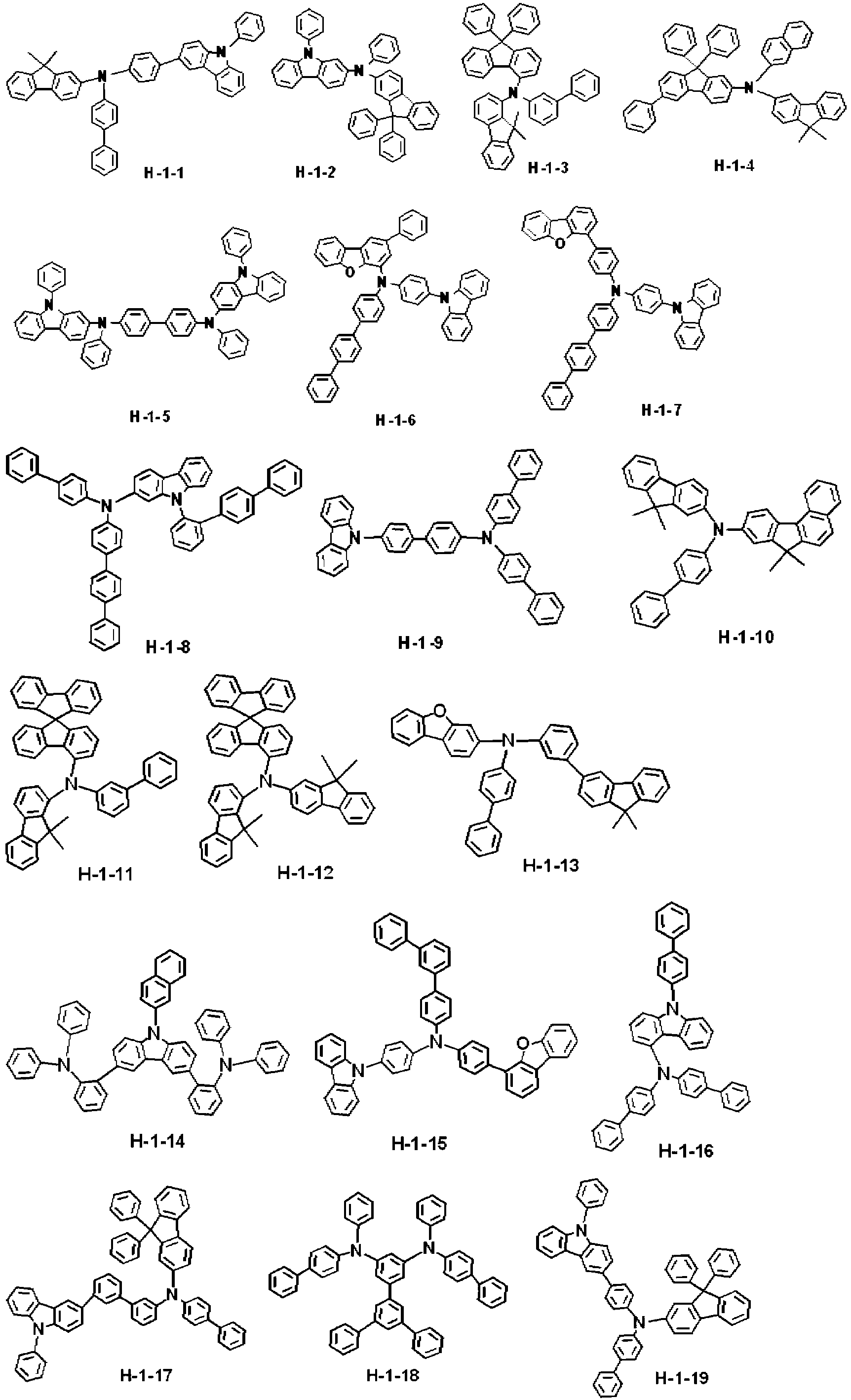

For example, in one or more embodiments, the hole transport region HTR may include a phthalocyanine compound, such as copper phthalocyanine, N¹,N¹'-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4'4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonicacid (PANI/CSA), polyaniline/poly(4-styrenesulfonate) (PANI/PSS), N,N'-di(naphthalen-1-yl)-N,N'-diphenyl-benzidine (NPB), a polyetherketone containing triphenylamine (TPAPEK), 4-isopropyl-4'-methyldiphenyliodonium [tetrakis(pentafluorophenyl)borate], dipyrazino[2,3-f: 2',3'-h] quinoxaline-2,3,6,7,10,11-hexacarbonitrile (HATCN), and/or the like.

The hole transport region HTR may also include a carbazole-based derivative, such as N-phenylcarbazole and polyvinylcarbazole, a fluorene-based derivative, a triphenylamine-based derivative such as N,N'-bis(3-methylphenyl)-N,N'-diphenyl-[1,1'-biphenyl]-4,4'-diamine (TPD), and 4,4',4"-tris(N-carbazolyl)triphenylamine (TCTA), N,N'-di(naphthalen1-yl)-N,N'-diphenyl-benzidine (NPB), 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 1,3-bis(N-carbazolyl)benzene (mCP), and/or the like.

In addition, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport region HTR may include the compounds described above of the hole transport region in at least one of the hole injection layer HIL, the hole transport layer HTL, or the buffer layer BUF.

In addition to the materials described above, the hole transport region HTR may further include a charge-generating material for improvement of conductivity. The charge-generating material may be distributed evenly or unevenly in the hole transport region HTR. The charge-generating material may be, for example, a p-dopant. The p-dopant may include at least one of a halide metal compound, a quinone derivative, a metal oxide, or a compound containing a cyano group, but the present disclosure is not limited thereto. For example, the p-dopant may include a halide metal compound such as Cul and Rbl, a quinone derivative such as tetracyanoquinodimethane (TCNQ) and 2,3,5,6-tetrafluoro-7,7'8,8-tetracyanoquinodimethane (F4-TCNQ), a metal oxide such as a tungsten oxide and a molybdenum oxide, and a compound containing a cyano group such as dipyrazino[2,3-f:2',3'-h] quinoxaline-2,3,6,7,10,11-hexacarbonitrile (HATCN) and 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), but embodiments are not limited thereto.

The hole transport region HTR may have a thickness of about 100 Å to about 10,000 Å, and for example, about 100 Å to about 5,000 Å. When the hole transport region HTR includes the hole injection layer HIL, the thickness of the hole injection layer HIL may be, for example, about 30 Å to about 1,000 Å. When the hole transport region HTR includes the hole transport layer HTL, the thickness of the hole transport layer HTL may be, for example, about 30 Å to about 1,000 Å. When the hole transport region HTR includes the buffer layer BUF, the thickness of the buffer layer BUF may be about 30 Å to about 1,000 Å. When the thicknesses of the hole transport region HTR, the hole injection layer HIL, the hole transport layer HTL, and the buffer layer BUF fall within the ranges described above, respectively, satisfactory hole transport characteristics may be achieved without substantial increase of driving voltage.

The light-emitting unit EP may be provided onto the hole transport region HTR. The light-emitting unit EP includes a first emission layer EML1, a second emission layer EML2, and a third emission layer EML3. The light-emitting unit EP includes an intermediate layer IL arranged between the second emission layer EML2 and the third emission layer EML3. The first emission layer EML1 may be arranged on the hole transport region HTR, the second emission layer EML2 may be arranged on the first emission layer EML1, the intermediate layer IL may be arranged on the second emission layer EML2, and the third emission layer EML3 may be arranged on the intermediate layer IL. The second emission layer EML2 may be directly arranged on the first emission layer EML1, the intermediate layer IL may be directly arranged on the second emission layer EML2, and the third emission layer EML3 may be directly arranged on the intermediate layer IL.

The first emission layer EML1 generates light with a first wavelength, the second emission layer EML2 generates light with a second wavelength, and the third emission layer EML3 generates light with a third wavelength. The first wavelength may be about 600 nm or greater and about 670 nm or less, the second wavelength may be about 500 nm or greater and about 570 nm or less, and the third wavelength may be about 400 nm or greater and about 470 nm or less. The first emission layer EML1 may generate red color light, the second emission layer EML2 may generate green color light, and the third emission layer EML3 may generate blue color light.

The first emission layer EML1 and the second emission layer EML2 may each be a phosphorescent emission layer. The first emission layer EML1 may have a first thickness of about 10 nm or greater and about 30 nm or less, and the second emission layer EML2 may have a second thickness of about 1 nm or greater and about 10 nm or less. For example, the first thickness may be about 15 nm or greater and about 25 nm or less, and the second thickness may be about 1 nm or greater and about 5 nm or less.

The first emission layer EML1 may include a first host and a first dopant, and the second emission layer EML2 may include a second host and a second dopant.

The first host and the second host may include a general material suitable in the relevant art. For example, the first host and the second host may each independently include bis (4-(9H-carbazol-9-yl) phenyl) diphenylsilane (BCPDS), (4-(1-(4-(diphenylamino) phenyl) cyclohexyl) phenyl) diphenyl-phosphine oxide (POPCPA), bis[2-(diphenylphosphino)phenyl] ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), N,N'-bis(naphthalen-1-yl)-N,N'-bis(phenyl)-2,2'-dimethylbenzidine (α-NPD), 4,4',4"-tris(carbazol-9-yl)-triphenylamine (TCTA) , and/or 1,3,5-tris(1-phenyl-1H-benzo[d]imidazole-2-yl)benzene (TPBi). However, embodiments are not limited thereto, and for example, tris(8-hydroxyquinolinato)aluminum (Alq3), 9,10-di(naphthalen-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetra siloxane (DPSiO₄), and/or the like may be used as a host material.

The first host and the second host may each independently include a compound represented by Formula E-2a or Formula E-2b. The compound represented by Formula E-2a or Formula E-2b may be used as a host material of a phosphorescent element.

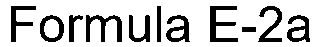

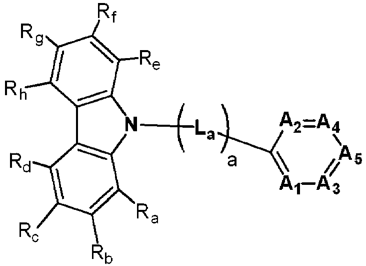

In Formula E-2a, a is an integer of 0 or greater and 10 or less, and Lₐ may be a direct linkage, a substituted or unsubstituted arylene group having 6 to 30 ring-forming carbon atoms, or a substituted or unsubstituted heteroarylene group having 2 to 30 ring-forming carbon atoms. When a is an integer of 2 or greater, Lₐ in plurality may each independently be a substituted or unsubstituted arylene group having 6 to 30 ring-forming carbon atoms, or a substituted or unsubstituted heteroarylene group having 2 to 30 ring-forming carbon atoms.

In addition, in Formula E-2a, A₁ to A₅ may each independently be N or CRᵢ. Rₐ to Rᵢ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may each be optionally bonded to an adjacent group to form a ring. Rₐ to Rᵢ may each be bonded to an adjacent group to form a hydrocarbon ring or a heterocycle containing N, O, S, and/or the like, as a ring-forming atom.

In Formula E-2a, two or three selected from among A₁ to A₅ may be N, and the rest may be CRᵢ.

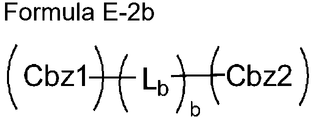

In Formula E-2b, Cbz1 and Cbz2 may each independently be an unsubstituted carbazole group, or a carbazole group substituted with an aryl group having 6 to 30 ring-forming carbon atoms. L_{b} may be a direct linkage, a substituted or unsubstituted arylene group having 6 to 30 ring-forming carbon atoms, or a substituted or unsubstituted heteroarylene group having 2 to 30 ring-forming carbon atoms. When b is an integer of 0 or greater and 10 or less, and b is an integer of 2 or greater, L_{b} in plurality may each independently be a substituted or unsubstituted arylene group having 6 to 30 ring-forming carbon atoms, or a substituted or unsubstituted heteroarylene group having 2 to 30 ring-forming carbon atoms.

The compound represented by Formula E-2a or Formula E-2b may be represented by any one among (e.g., any one selected from among) the compounds of Compound Group E-2. However, the compounds listed in Compound Group E-2 are examples, and the compound represented by Formula E-2a or Formula E-2b is not limited to those listed in Compound Group E-2.

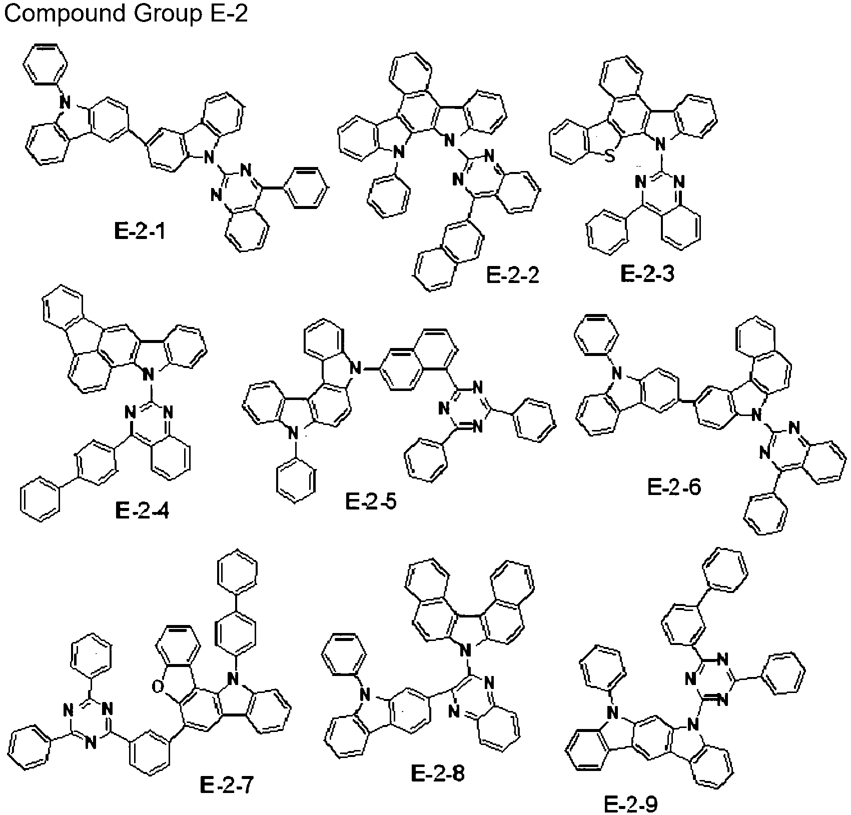

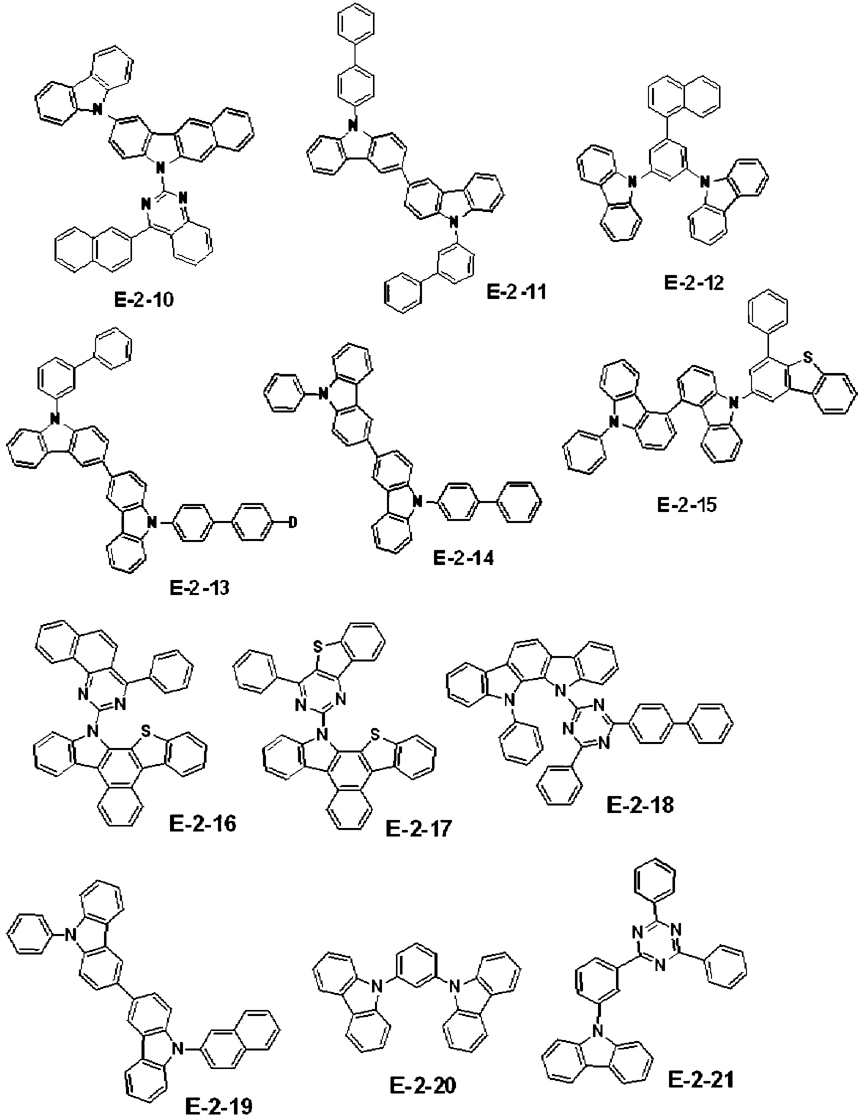

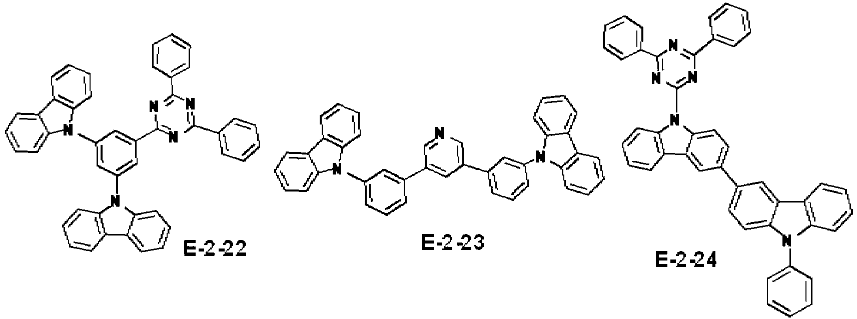

In or or more embodiments,the first dopant and the second dopant may each independently be a metal complex containing iridium (Ir), platinum (Pt), osmium (Os), gold (Au), titanium (Ti), zirconium (Zr), hafnium (Hf), europium (Eu), terbium (Tb), or thulium (Tm). For example, iridium(III) bis(4,6-difluorophenylpyridinato-N,C2')picolinate (Flrpic), bis(2,4-difluorophenylpyridinato)-tetrakis(1-pyrazolyl)borate iridium(III) (Fir6), and/or platinum octaethyl porphyrin (PtOEP) may be used as a phosphorescent dopant.

The first dopant and the second dopant may each independently include a compound represented by Formula D. The compound represented by Formula D may be used as a phosphorescent dopant material. However, embodiments are not limited thereto.

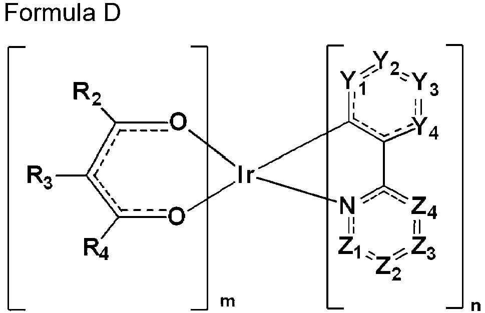

In Formula D above, Y₁ to Y₄ and Z₁ to Z₄ may each independently be CR₁ or N, and R₁ to R₄ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be optionally bonded to an adjacent group to form a ring.

In Formula D, m is 0 or 1, and n is 2 or 3. In Formula M-a, if (e.g., when) m is 0, n is 3, and if (e.g., when) m is 1, n is 2.

The compound represented by Formula D may be expressed by any one among (e.g., any one selected from among) Compounds M-a1 to M-a27. However, Compounds M-a1 to M-a27 are examples, and the compound represented by Formula M-a is not limited to those expressed by Compounds M-a1 to M-a27.

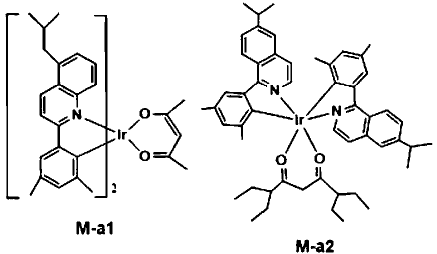

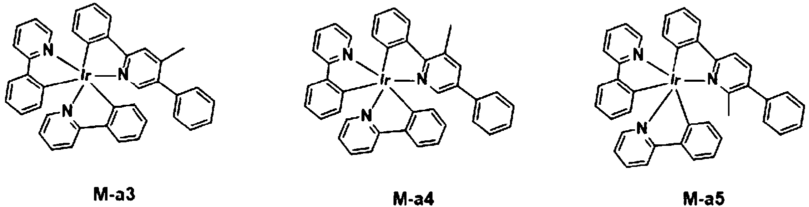

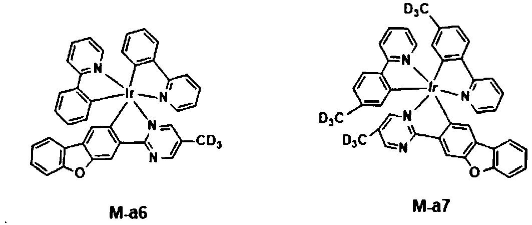

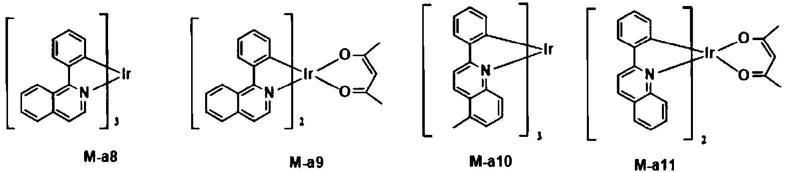

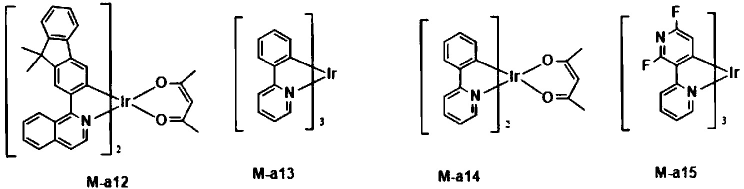

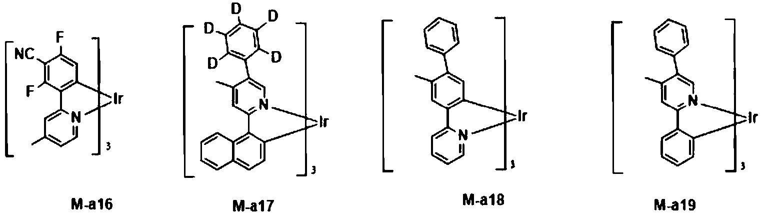

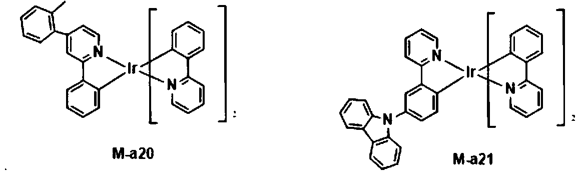

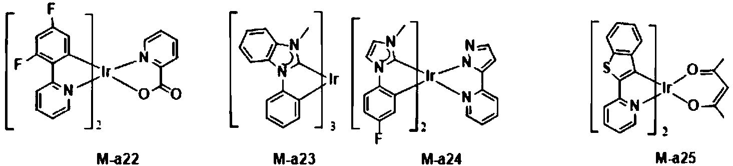

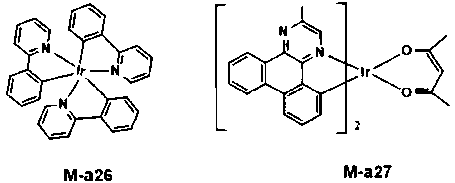

In one or more embodiments, the intermediate layer IL may be a phosphorescent emission layer, and the third emission layer EML3 may be a fluorescent emission layer. A (3-1)-th thickness of the intermediate layer IL may be less than a (3-2)-th thickness of the third emission layer EML3. The (3-1)-th thickness may be about 1 nm or greater and about 10 nm or less, and the (3-2)-th thickness may be about 5 nm or greater and about 20 nm or less. For example, the (3-1)-th thickness may be about 1 nm or greater and about 5 nm or less, and the (3-2)-th thickness may be about 5 nm or greater and about 15 nm or less.

The intermediate layer IL includes a first compound containing a phosphorescent material. The first compound may include a hole-transporting host, an electron-transporting host, and a phosphorescent dopant.

The intermediate layer IL may include a compound represented by Formula 1. The phosphorescent dopant included in the intermediate layer IL may include a compound represented by Formula 1. A weight percentage of the phosphorescent dopant relative to a total weight of the intermediate layer IL may be about 0.1% or greater and about 5.0% or less. For example, if (e.g., when) the intermediate layer IL includes all of the hole-transporting host, the electron-transporting host, and the phosphorescent dopant, the weight percentage of the phosphorescent dopant may be about 1% or greater and about 3% or less on the basis of the total weight of the hole-transporting host, the electron-transporting host, and the phosphorescent dopant.

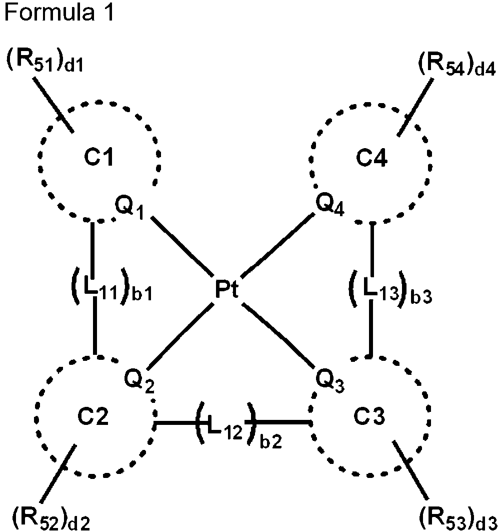

In Formula 1, Q₁ to Q₄ may each independently be C or N.

In Formula 1, C1 to C4 may each independently be a substituted or unsubstituted hydrocarbon ring having 5 to 30 ring-forming carbon atoms, or a substituted or unsubstituted heterocycle having 2 to 30 ring-forming carbon atom.

In Formula 1, L₁₁ to L₁₃ may each independently be a direct linkage, 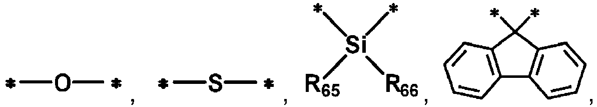 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, "-*" refers to portions to be connected to C1 to C4.

In Formula 1, b1 to b3 may each independently be 0 or 1. When b1 is 0, C1 and C2 may not be connected to each other. When b2 is 0, C2 and C3 may not be connected to each other. When b3 is 0, C3 and C4 may not be connected to each other.

In Formula 1 above, R₆₁ to R₆₆ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, R₆₁ to R₆₆ may each be bonded to an adjacent group to form a ring. R₆₁ to R₆₆ may each independently be a substituted or unsubstituted methyl group, or a substituted or unsubstituted t-butyl group.

In Formula 1, d1 to d4 may each independently be an integer of 0 or greater and 4 or less. In Formula D-1, if (e.g., when) each of d1 to d4 is 0, a fourth compound may not be substituted with R₆₁ to R₆₄. When each of d1 to d4 is 4, and each of R₆₁ to R₆₄ is a hydrogen atom, the case may be the same as the case in which each of d1 to d4 is 0. When each of d1 to d4 is an integer of 2 or greater, R₆₁ to R₆₄ provided in plurality may be the same to each other, or at least one selected from among R₆₁ to R₆₄ in plurality may be different.

In Formula 1, C1 to C4 may each independently be a substituted or unsubstituted hydrocarbon ring or a substituted or unsubstituted heterocycle expressed by any one among (e.g., selected from among) C-1 to C-4.

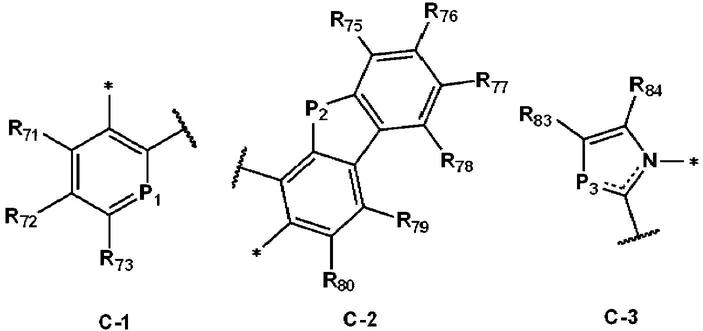

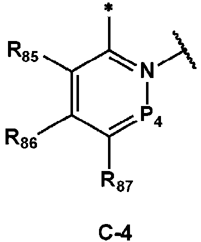

In C-1 to C-4, P₁- may be C-* or CR₇₄, P₂ may be N-* or NR₈₁, P₃ may be N-* or NR₈₂, and P₄ may be C-* or CR₈₈. R₇₁ to R₈₈ may each independently be a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or may each be optionally bonded to an adjacent group to form a ring.

In addition, in C-1 to C-4, " 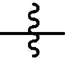 "corresponds to a portion connected to Pt that is a central metal atom, and "-*" corresponds to a portion connected to an adjacent ring group (C1 to C4) or a linker (L₁₁ to L₁₃).

In one or more embodiments, the first compound represented by Formula 1 may be expressed by any one of (e.g., selected from among) compounds listed in Compound Group 1. The intermediate layer IL may include at least one of (e.g., selected from among) the compounds listed by Compound Group 1 as a phosphorescent dopant material.

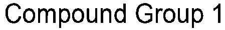

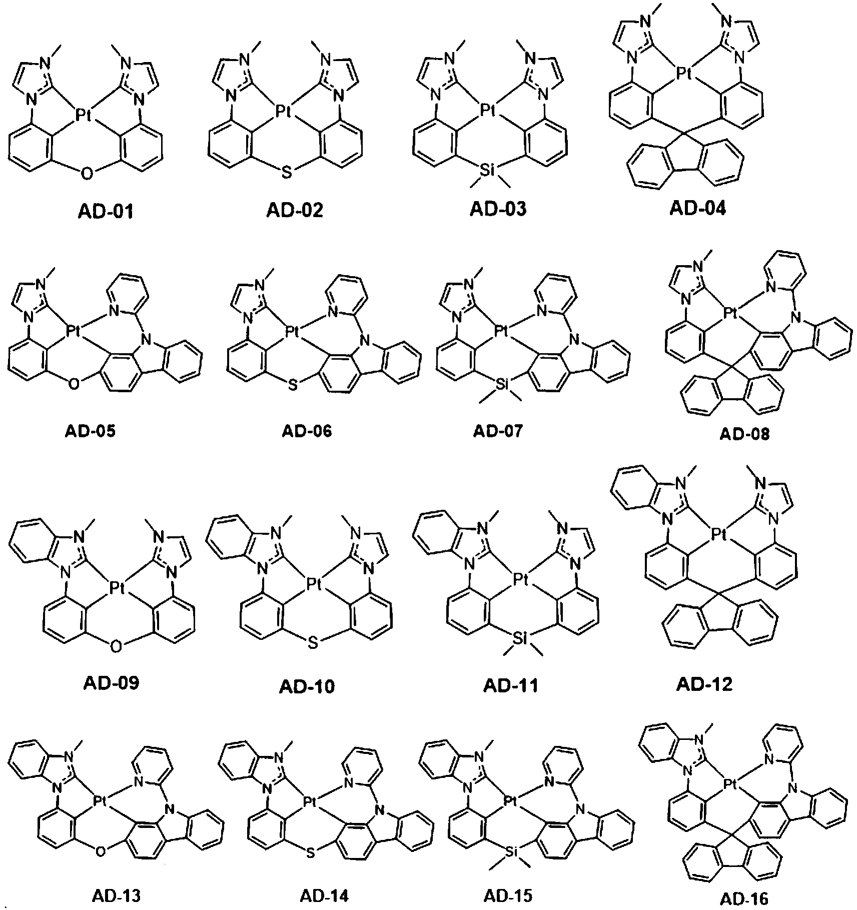

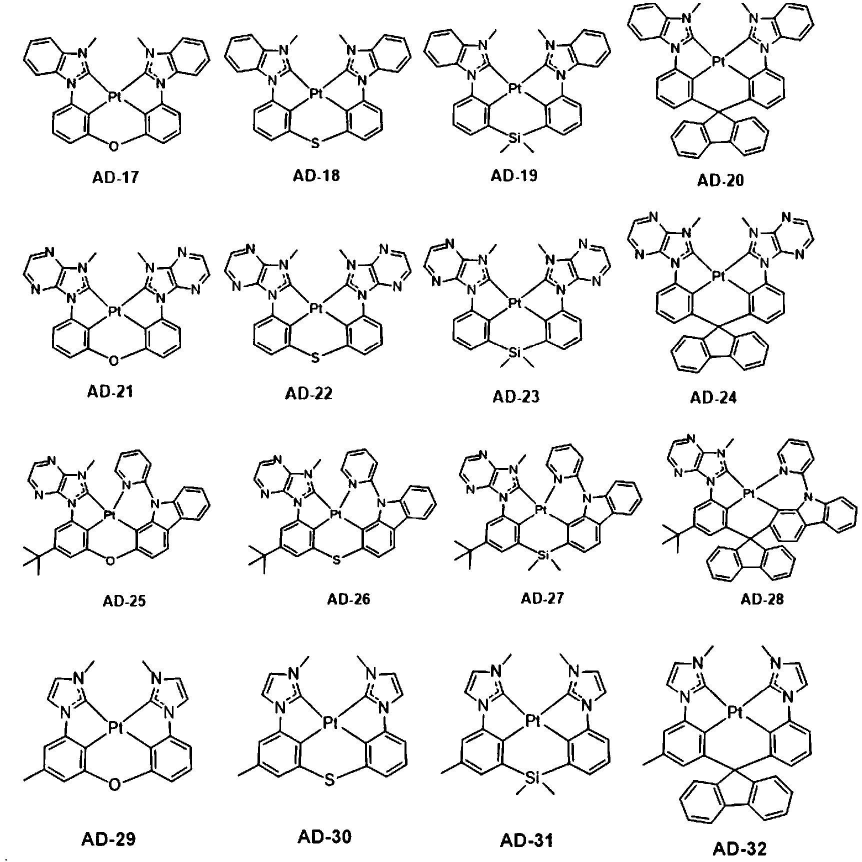

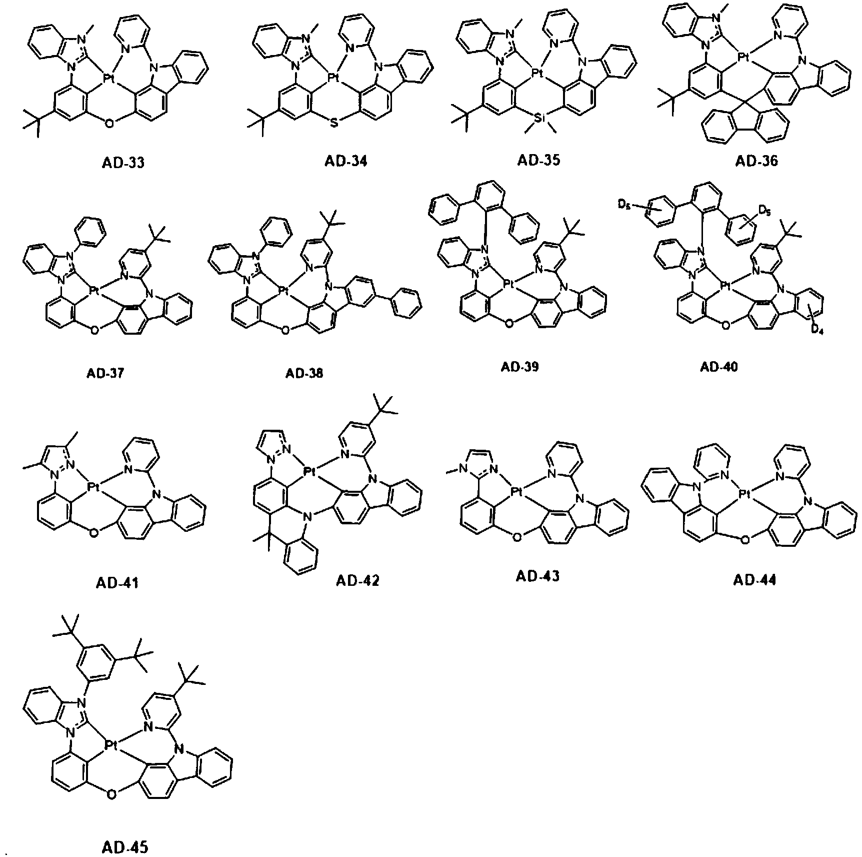

In the example compounds presented in Compound Group 1, "D" refers to a deuterium atom.

The intermediate layer IL may include a compound represented by Formula H1. The hole-transporting host included in the intermediate layer IL may include a compound represented by Formula H1.

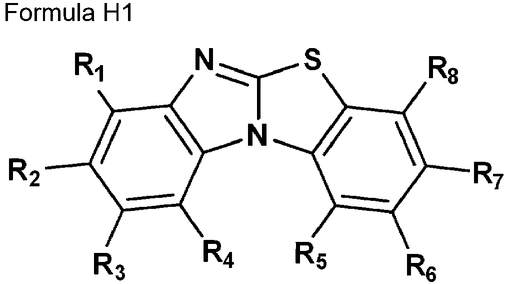

In Formula H1, R₁ to R₈ may each independently be hydrogen, deuterium, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may each be optionally bonded to an adjacent group to form a ring. For example, R₁ to R₈ may each independently be a hydrogen atom, a deuterium atom, or a substituted or unsubstituted heteroaryl group having 2 to 30 ring-forming carbon atoms.

In one or more embodiments, the compound represented by Formula H1 may be expressed by any one of (e.g., selected from among) compounds listed in Compound Group 2-1. The intermediate layer IL may include at least one of (e.g., selected from among) the compounds listed in Compound Group 2-1 as a hole-transporting host material.

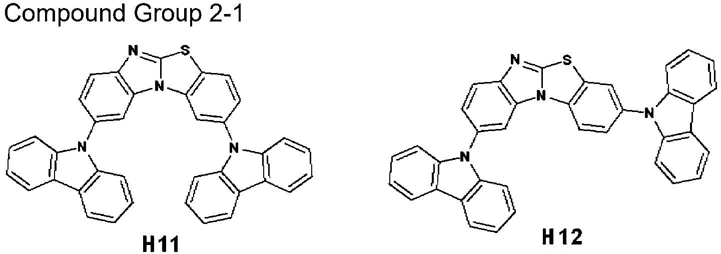

The intermediate layer IL may include a compound represented by Formula HT-1. The hole-transporting host included in the intermediate layer IL may include a compound represented by Formula HT-1.

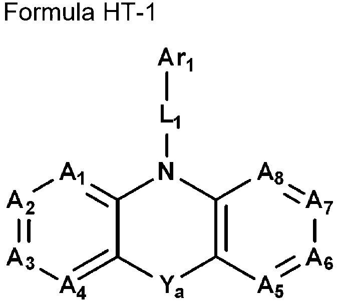

In Formula HT-1, A₁ to A₈ may each independently be N or CR₅₁. For example, A₁ to A₈ may be all CR₅₁. In one or more embodiments, any one among A₁ to A₈ may be N, and the rest may be CR₅₁.

In Formula HT-1, L₁ may be a direct linkage, a substituted or unsubstituted arylene group having 6 to 30 ring-forming carbon atoms, or a substituted or unsubstituted heteroarylene group having 2 to 30 ring-forming carbon atoms. For example, L₁ may be a direct linkage, a substituted or unsubstituted phenylene group, a substituted or unsubstituted divalent biphenyl group, a substituted or unsubstituted divalent carbazole group, and/or the like, but embodiments are not limited thereto.

In Formula HT-1, Yₐ may be a direct linkage, CR₅₂R₅₃, or SiR₅₄R₅₅. For example, in Formula HT-1, it refers to that two benzene rings connected to a nitrogen atom may be connected through a direct linkage, 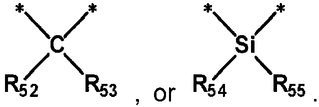 In Formula HT-1, if (e.g., when) Yₐ is a direct linkage, a substituent represented by Formula HT-1 may include a carbazole moiety.

In Formula HT-1, Ar₁ may be a substituted or unsubstituted aryl group having 6 to 30 ring-forming carbon atoms, or a substituted or unsubstituted hetero aryl group having 2 to 30 ring-forming carbon atoms. For example, Ar₁ may be a substituted or unsubstituted carbazole group, a substituted or unsubstituted dibenzofuran group, a substituted or unsubstituted dibenzothiophene group, a substituted or unsubstituted biphenyl group, and/or the like, but embodiments are not limited thereto.

In Formula HT-1, R₅₁ to R₅₅ may each independently be hydrogen, deuterium, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, R₅₁ to R₅₅ may each be bonded to an adjacent group to form a ring. For example, R₅₁ to R₅₅ may each independently be hydrogen or deuterium. R₅₁ to R₅₅ may each independently be an unsubstituted methyl group, or an unsubstituted phenyl group.

In one or more embodiments, the compound represented by Formula HT-1 may be expressed by any one of (e.g., selected from among) compounds listed in Compound Group 2-2. The intermediate layer IL may include at least one of (e.g., selected from among) the compounds listed in Compound Group 2-2 as a hole-transporting host material.

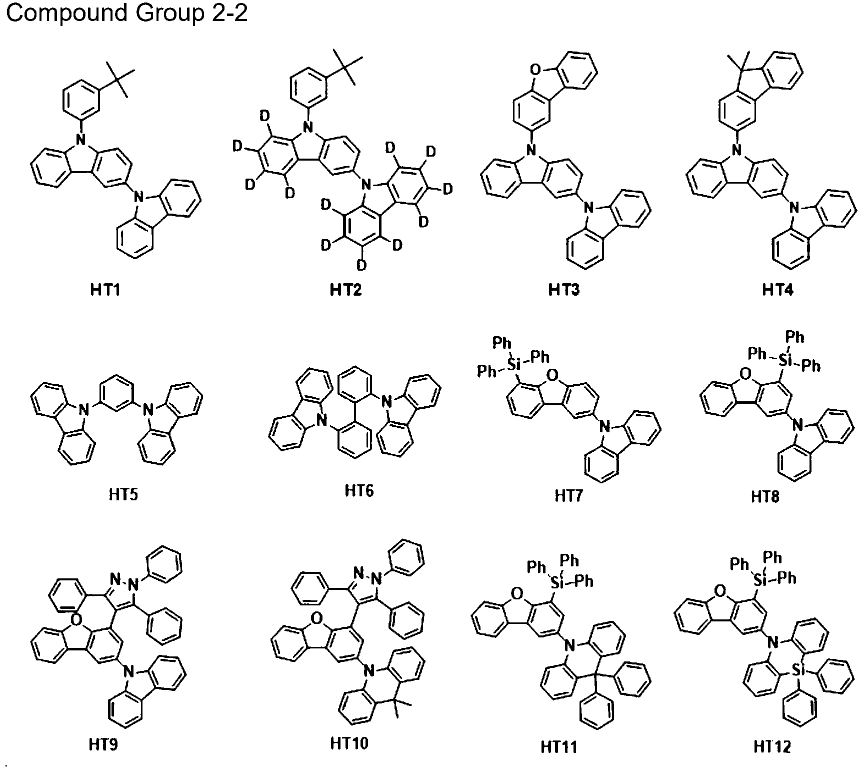

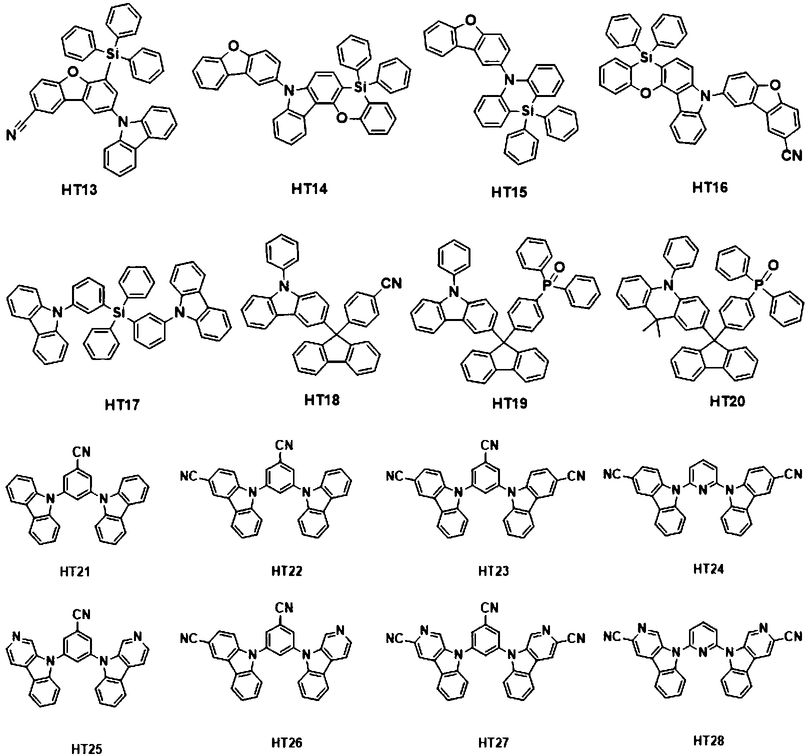

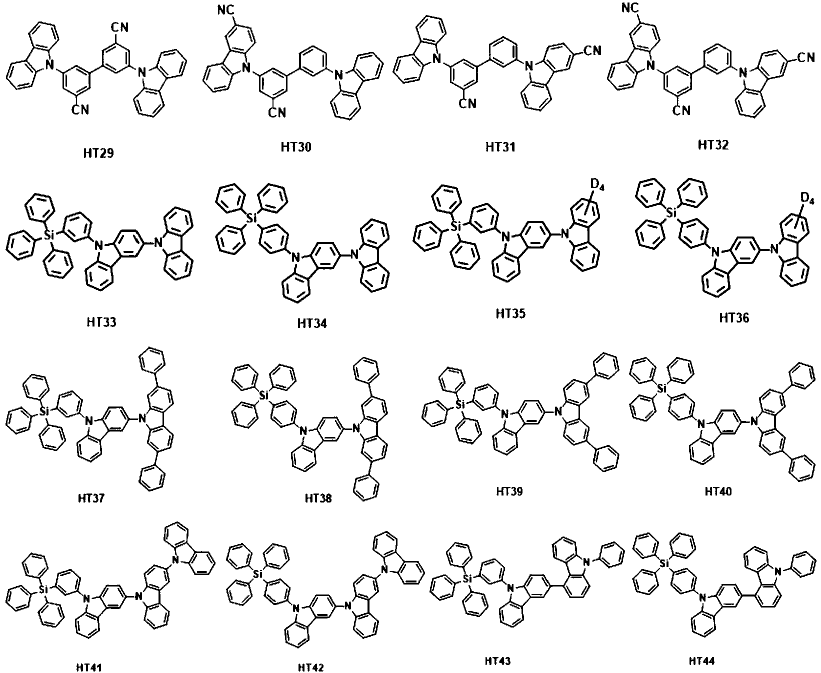

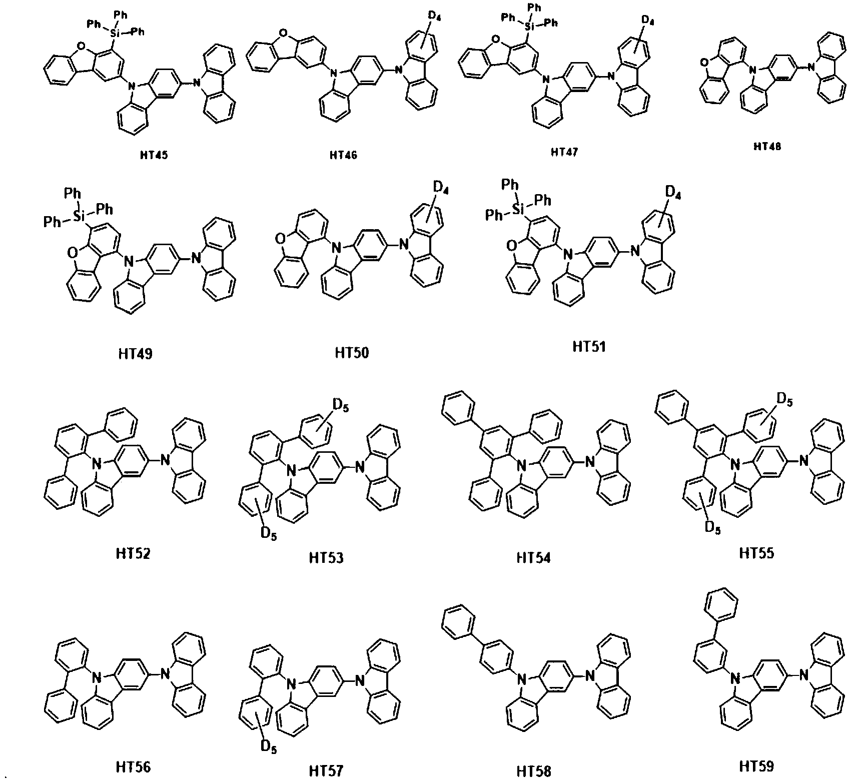

In the particular example compounds presented in Compound Group 2-2, "D" may refer to deuterium, and "Ph" may refer to a substituted or unsubstituted phenyl group. For example, the particular example compounds presented in Compound Group 2, "Ph" may be an unsubstituted phenyl group.

The intermediate layer IL may include a compound represented by Formula ET-1. The electron-transporting host included in the intermediate layer IL may include a compound represented by Formula ET-1.

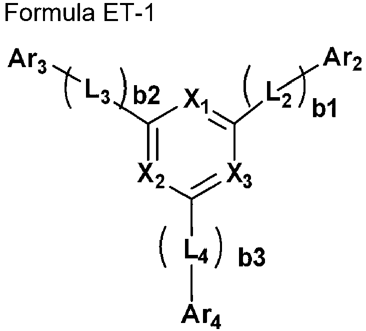

In Formula ET-1, at least one of X₁ to X₃ is N, and the rest are CR₉. For example, any one of X₁ to X₃ may be N, and the other two may each independently be CR₉. In this regard, a third compound represented by Formula ET-1 may include a pyridine moiety. In one or more embodiments, two of X₁ to X₃ may be N, and the other one may be CR₉. In this regard, the third compound represented by Formula ET-1 may include a pyrimidine moiety. In one or more embodiments, X₁ to X₃ may be all N. In one or more embodiments, the third compound represented by Formula ET-1 may include a triazine moiety.

In Formula ET-1, R₉ may be hydrogen, deuterium, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, b1 to b3 may each independently be an integer of 0 or greater and 10 or less.

In Formula ET-1, Ar₁ to Ar₃ may each independently be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Ar₂ to Ar₄ may be a substituted or unsubstituted phenyl group or a substituted or unsubstituted carbazole group.

In Formula ET-1, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. When b1 to b3 are each an integer of 2 or greater, L₁ to L₃ may each independently be a substituted or unsubstituted arylene group having 6 to 30 ring-forming carbon atoms, or a substituted or unsubstituted heteroarylene group having 2 to 30 ring-forming carbon atoms.

In one or more embodiments, the compound represented by Formula ET-1 may be expressed by any one of (e.g., selected from among) compounds in Compound Group 3. The intermediate layer IL may include at least one of (e.g., selected from among) the compounds listed by Compound Group 3 as an electron-transporting host material.

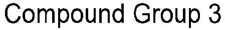

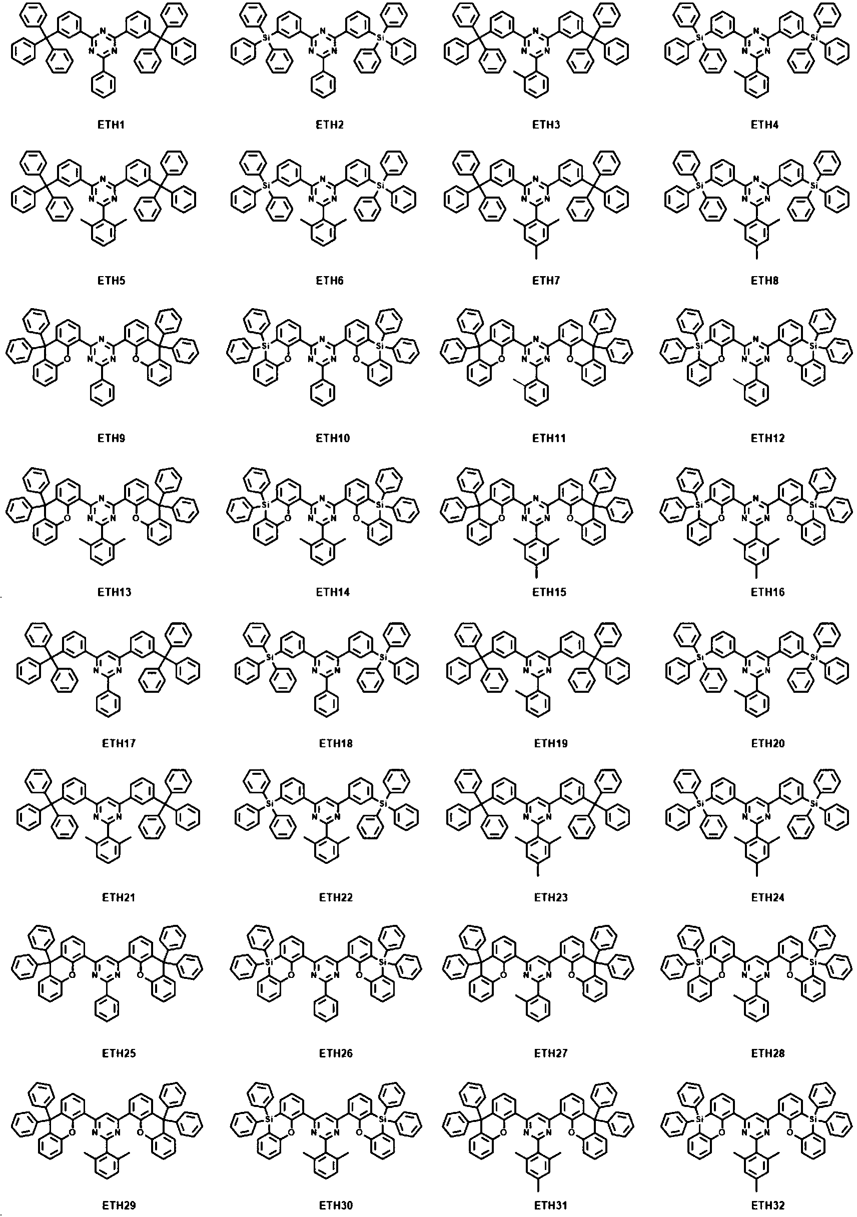

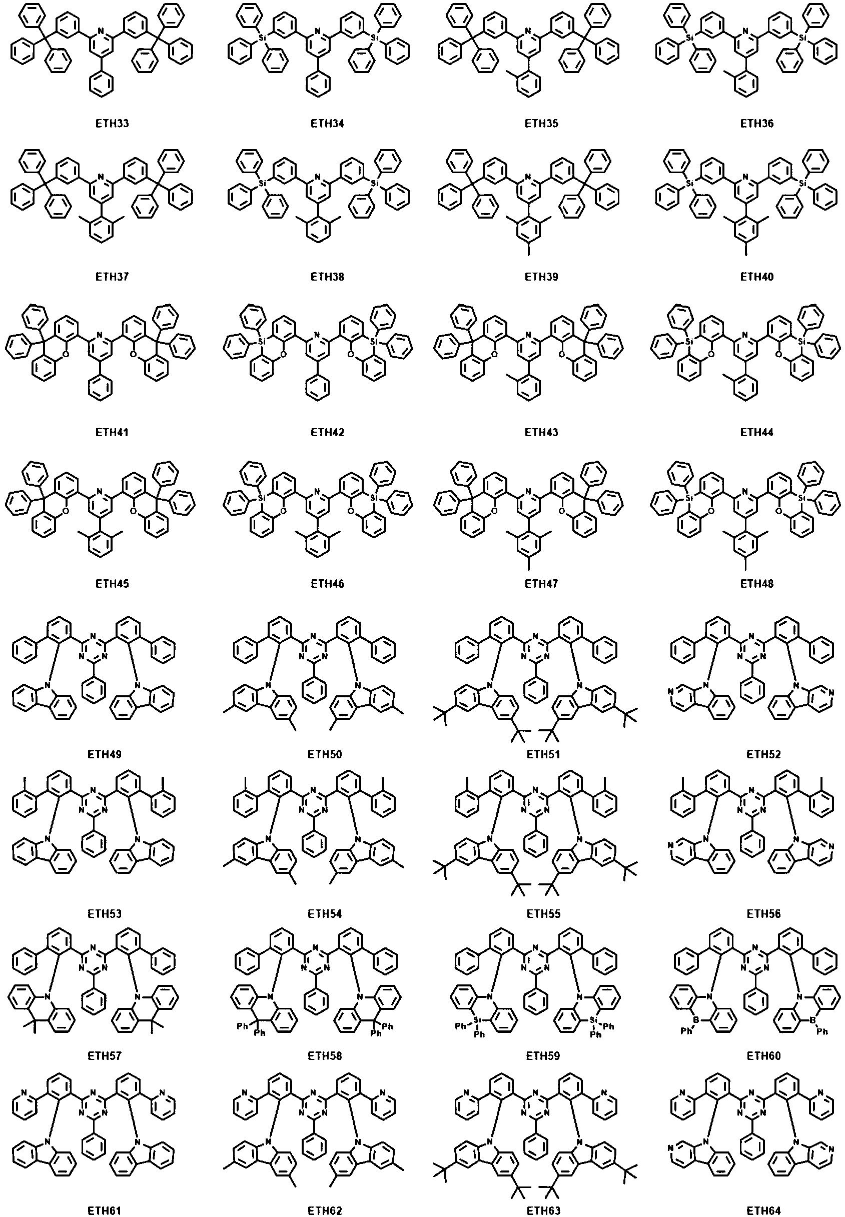

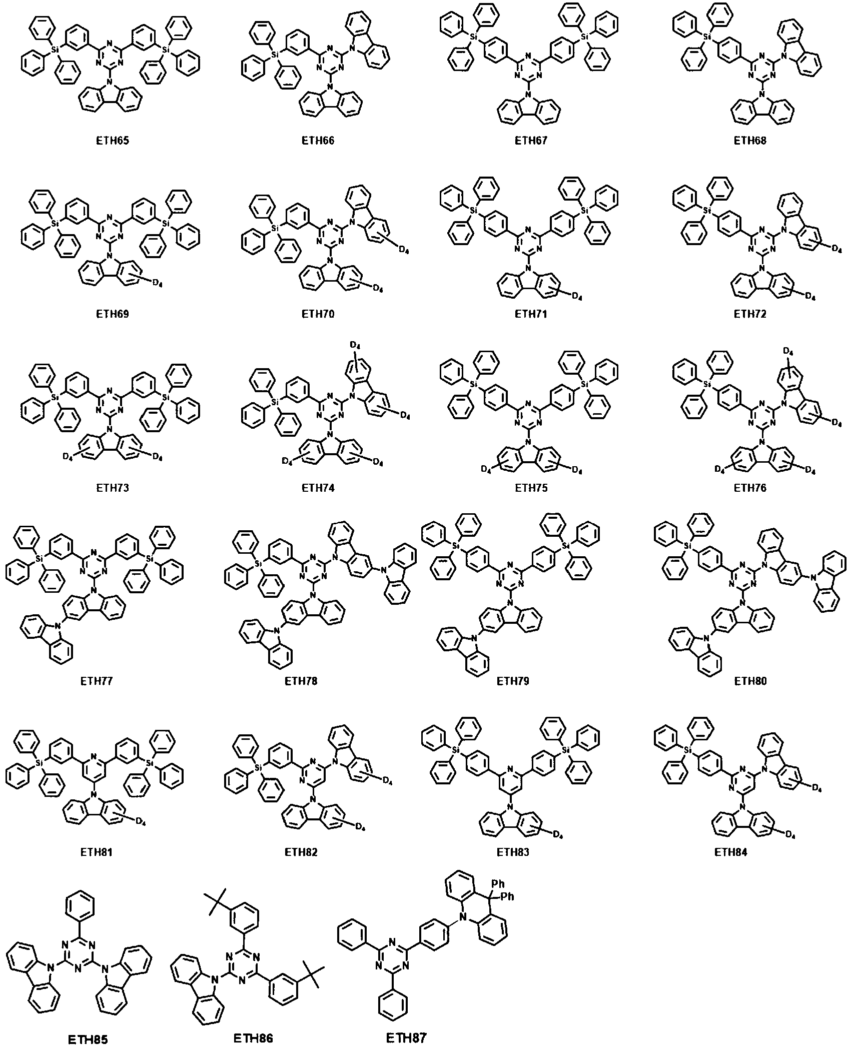

In the example compounds presented in Compound Group 3, "D" refers to deuterium, and "Ph" refers to an unsubstituted phenyl group.

The phosphorescent dopant may include a central metal atom, and include an organic metal complex containing ligands bonded to the central metal atom.

The third emission layer EML3 includes a second compound containing a fluorescent material. The second compound may include a spiro compound. The second compound may include a spiro-DPVBi or spiro-6P. In one or more embodiments, the second compound may include any one selected from among the group consisting of a distyryl-benzene (DSB), distyryl-arylene (DSA), and polyfluorene (PFO)-based polymers, and a poly(p-phenylene vinylene) (PPV)-based polymer.

The third emission layer EML3 may further include a compound represented by Formula F-a. The compound represented by Formula F-a may be used as a fluorescent dopant material.

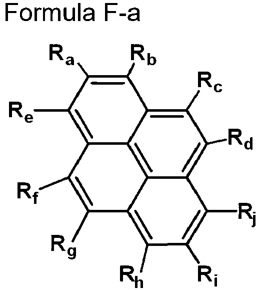

In Formula F-a above, two selected from among Rₐ to Rⱼ may each independently be substituted with *-NAr₁Ar₂. The rest not substituted with *-NAr₁Ar₂ among Rₐ to Rⱼ may each independently be hydrogen, deuterium, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted hetero aryl group having 2 to 30 ring-forming carbon atoms. In *-NAr₁Ar₂, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. For example, at least one of Ar₁ or Ar₂ may be a hetero aryl group containing O or S as a ring-forming atom.

In one or more embodiments, the third emission layer EML3 may include, as a suitable dopant material, a styryl derivative (for example, 1, 4-bis[2-(3-N-ethylcarbazolyl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi)), 4,4'-bis[2-(4-(N,N-diphenylamino)phenyl)vinyl]biphenyl (DPAVBi), perylene and a derivative thereof (for example, 2, 5, 8, 11-tetra-t-butylperylene (TBP)), pyrene and a derivative thereof (for example, 1, 1-dipyrene, 1, 4-dipyrenylbenzene, 1, 4-bis(N, N-diphenylamino)pyrene), and/or the like.

The third emission layer EML3 may further include a compound represented by Formula E-1. The compound represented by Formula E-1 may be used as a fluorescent host material.

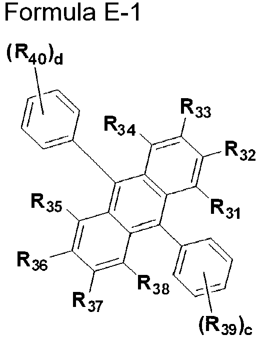

In Formula E-1, R₃₁ to R₄₀ may each independently be hydrogen, deuterium, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, or may each be optionally bonded to an adjacent group to form a ring. R₃₁ and R₄₀ may each be bonded to an adjacent group to form a saturated hydrocarbon ring, an unsaturated hydrocarbon ring, a saturated heterocycle, or an unsaturated heterocycle.

In Formula E-1, c and d may each independently be an integer of 0 or greater and 5 or less.

Formula E-1 may be expressed by any one among (e.g., selected from among) Compound E1 to Compound E19.

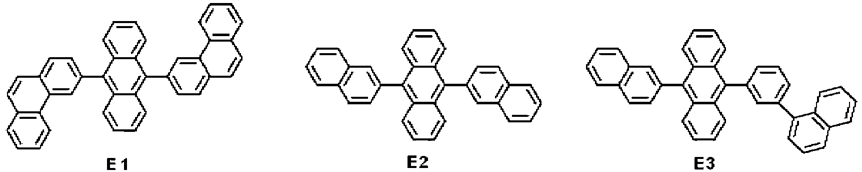

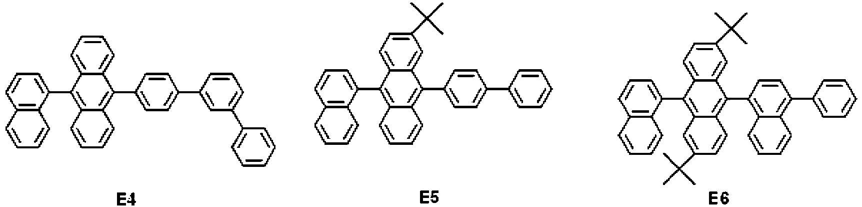

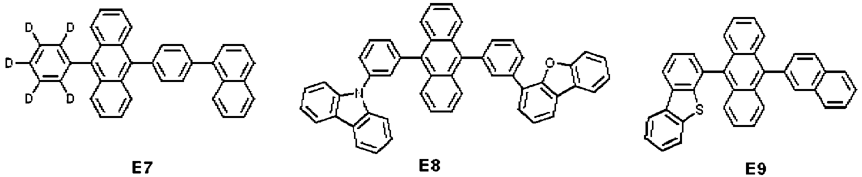

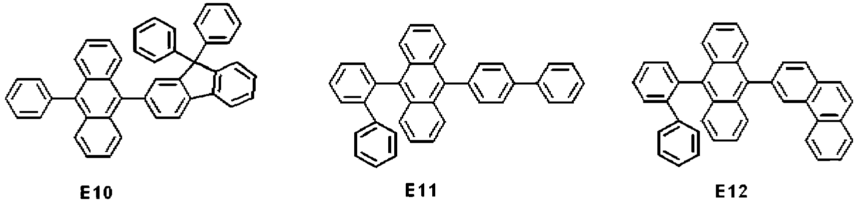

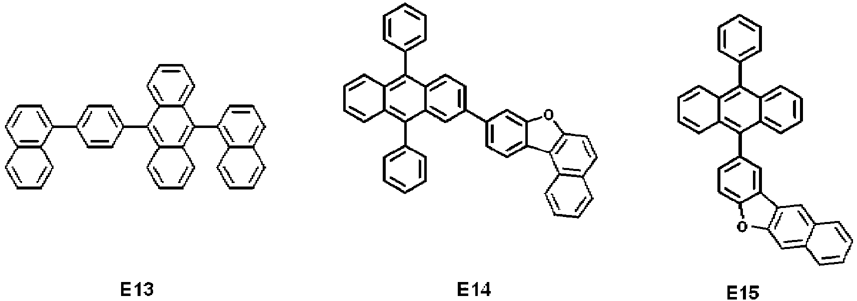

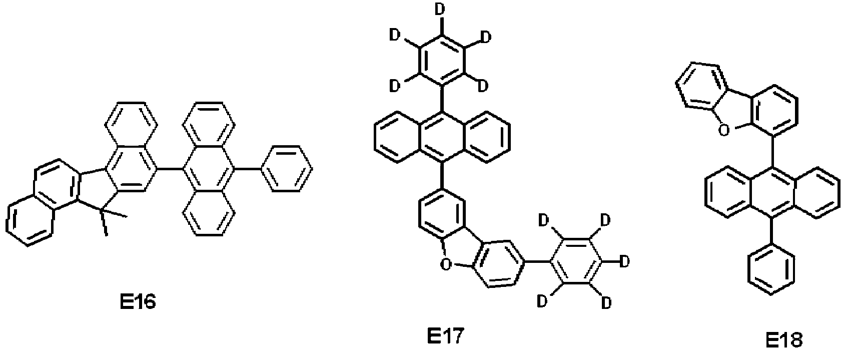

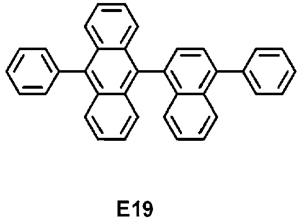

In one or more embodiments, the third emission layer EML3 may further include a suitable host material. For example, the third emission layer EML3 may further include a general material suitable in the relevant art previously described in the description related to the first host and the second host.

The electron transport region ETR may be provided onto the light-emitting unit EP. The electron transport region ETR may include an electron transport layer ETL and an electron injection layer EIL.

Contrary to what is illustrated in FIG. 7, the electron transport region ETR may have a single-layer structure including a plurality of different materials, or may have a structure of a hole-blocking layer/ electron transport layer ETL/ electron injection layer EIL sequentially stacked from the light-emitting unit EP, but the present disclosure is not limited thereto.

The electron transport region ETR may be formed using one or more suitable methods including vacuum deposition, spin coating, casting, Langmuir-Blodgett (LB), inkjet printing, laser printing, laser induced thermal imaging (LITI), and/or the like.

The electron transport region ETR may include a compound represented by Formula ET-2.

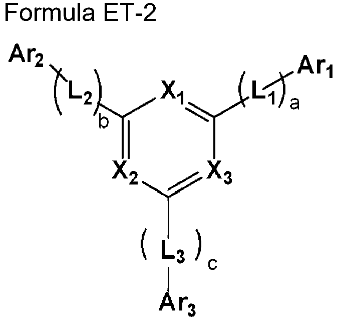

In Formula ET-2, at least one of X₁ to X₃ is N, and the rest are CRₐ. Rₐ may be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ may each independently be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer of 0 or greater and 10 or less. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. When each of a to c is an integer of 2 or greater, L₁ to L₃ may each independently be a substituted or unsubstituted arylene group having 6 to 30 ring-forming carbon atoms, or a substituted or unsubstituted heteroarylene group having 2 to 30 ring-forming carbon atoms.

For example, in one or more embodiments, the electron transport region ETR may include an anthracene-based compound. However, embodiments are not limited thereto, and the electron transport region ETR may include, for example, tris(8-hydroxyquinolinato)aluminum (Alq3), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzimidazol-1-yl)phenyl)-9,10-dinaphthylanthracene, 1,3,5-tri(1-phenyl-1H-benz[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenyl-4-yl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenyl-4-yl)-5-(4-tert-butylphenyl)-1,3,4-oxadiazole (tBu-PBD), bis(2-methyl-8-quinolinolato-N1,08)-(1,1'-biphenyl-4-olato)aluminum (BAlq), berylliumbis(benzoquinolin-10-olate) (Bebq2), 9,10-di(naphthalen-2-yl)anthracene (ADN), 1,3-bis[3,5-di(pyridin-3-yl)phenyl]benzene (BmPyPhB), or a mixture thereof.

The electron transport region ETR may include at least one (e.g., selected from) among Compounds ET1 to ET36.

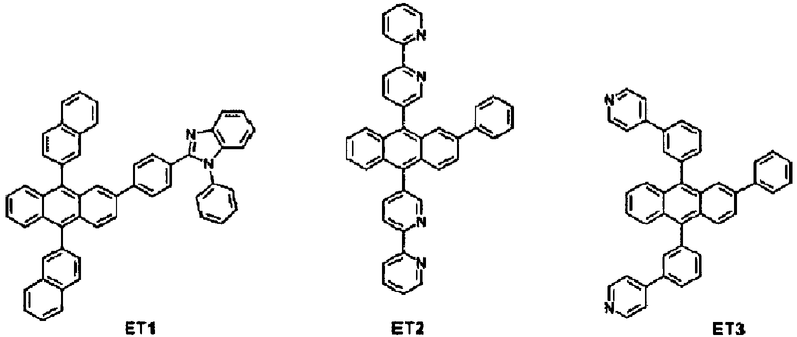

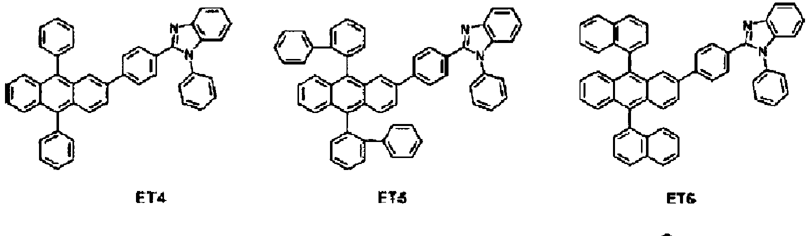

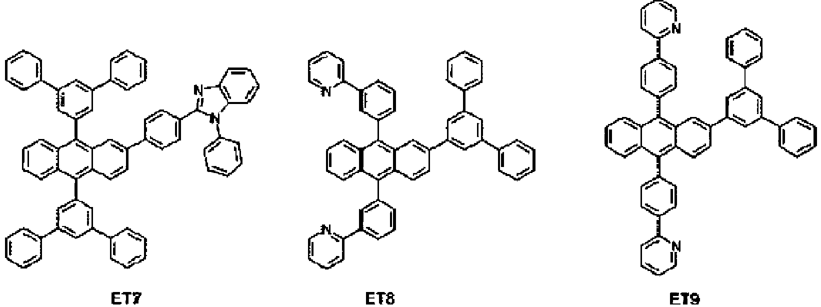

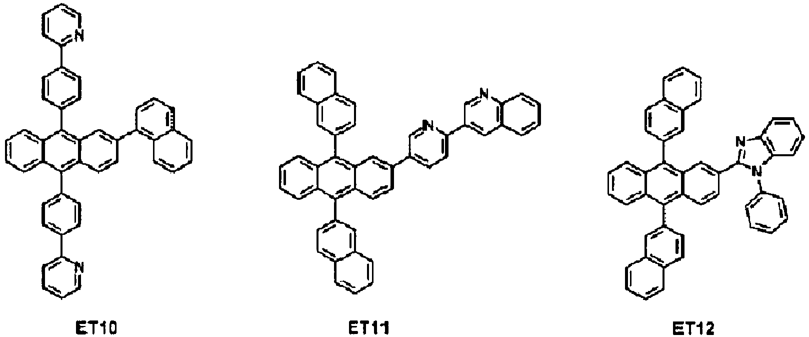

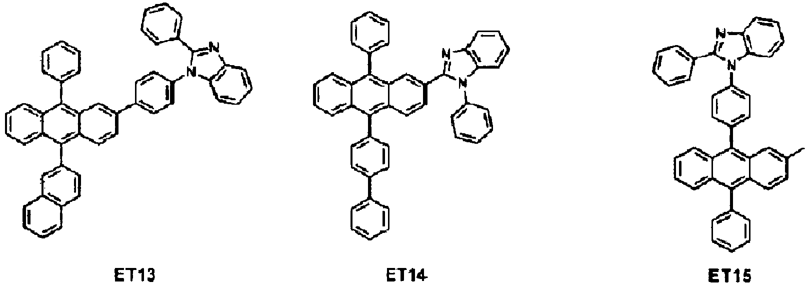

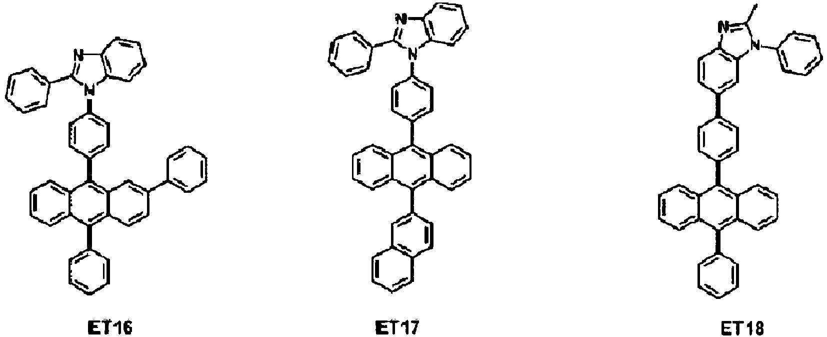

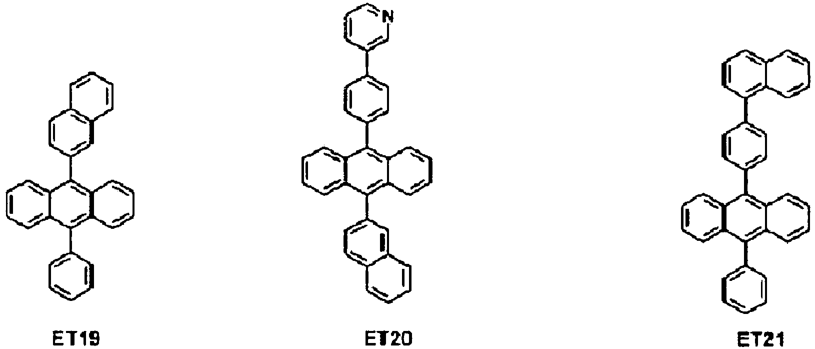

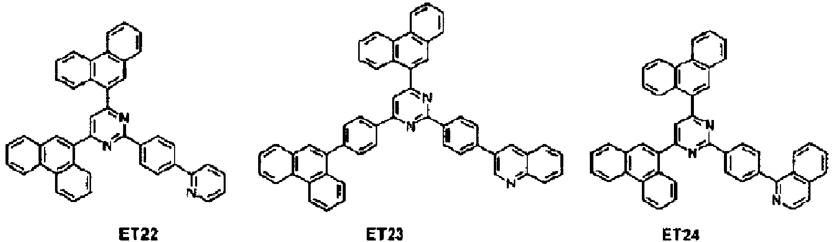

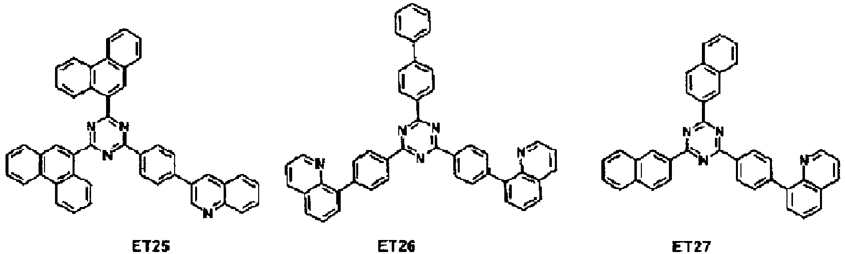

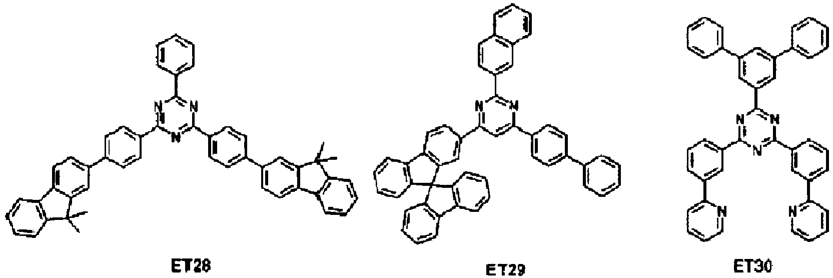

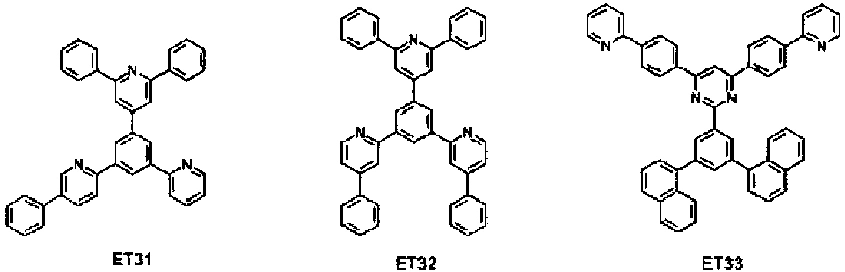

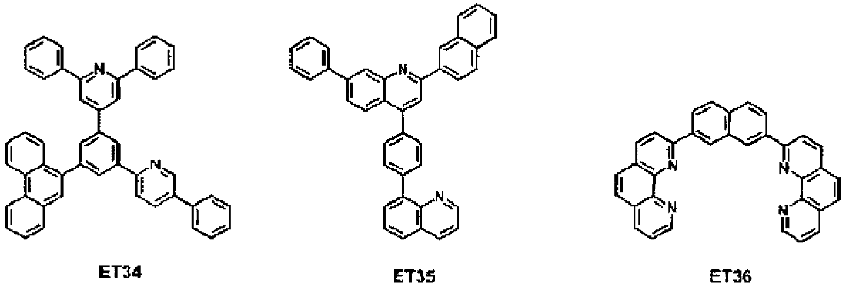

In one or more embodiments, the electron transport region ETR may include a halide metal such as LiF, NaCl, CsF, RbCl, Rbl, Cul, and/or KI, a lanthanide metal such as Yb, or a co-deposition material of the halide metal and the lanthanide metal. For example, the electron transport region ETR may include KI:Yb, Rbl:Yb, and LiF:Yb as a co-deposition material. For the electron transport region ETR, a metal oxide such as Li₂O and BaO, or 8-hydroxyl-lithium quinolate (Liq), and/or the like may be used, but embodiments are not limited thereto. The electron transport region ETR may also include a mixed material of an electron transport material and an organo metal salt with insulation. The organo metal salt may be a material having an energy band gap of about 4 eV or greater. For example, the organo metal salt may include metal acetate, metal benzoate, metal acetoacetate, metal acetylacetonate, or metal stearate.

The electron transport region ETR may further include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen), but embodiments are not limited thereto.

The electron transport region ETR may include the compounds described above of the electron transport region in at least one of the electron injection layer EIL or the electron transport layer ETL.

The electron transport region ETR may have a thickness of, for example, about 1000 Å to about 1500 Å. When the electron transport region ETR includes the electron transport layer ETL, the thickness of the electron transport layer ETL may be about 100 Å to about 1000 Å, and for example, about 150 Å to about 500 Å. When the thickness of the electron transport layer ETL falls within the above-described ranges, satisfactory electron transport characteristics may be achieved without substantial increase of driving voltage. When the electron transport region ETR includes the electron injection layer ElL, the thickness of the electron injection layer EIL may be about 1 Å to about 100 Å, or about 3 Å to about 90 Å. When the thickness of the electron injection layer EIL falls within the above-described ranges, satisfactory electron injection characteristics may be achieved without substantial increase of driving voltage.

For example, the electron transport region ETR may include an anthracene-based compound. However, embodiments are not limited thereto, and the electron transport region ETR may include tris(8-hydroxyquinolinato)aluminum (Alq3), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenyl-4-yl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenyl-4-yl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), berylliumbis(benzoquinolin-10-olate) (Bebq2), 9,10-di(naphthalen-2-yl)anthracene (ADN), 1,3-bis[3,5-di(pyridin-3-yl)phenyl]benzene (BmPyPhB), and a mixture thereof.

In addition, the electron transport region ETR may include a halide metal such as LiF, NaCl, CsF, RbCl, Rbl, Cul, and Kl, a lanthanide metal such as Yb, or a co-deposition material of the halide metal and the lanthanide metal. For example, the electron transport region ETR may include KI:Yb, Rbl:Yb, LiF:Yb, and/or the like as a co-deposition material. For the electron transport region ETR, a metal oxide such as Li₂O and BaO, 8-hydroxyl-lithium quinolate (Liq), and/or the like may be used, but embodiments are not limited thereto. The electron transport region ETR may also include a mixed material of an electron transport material and an organo metal salt with insulation. The organo metal salt may be a material having an energy band gap of about 4 eV or greater. For example, the organo metal salt may include metal acetate, metal benzoate, metal acetoacetate, metal acetylacetonate, or metal stearate.

In addition to the materials mentioned above, the electron transport region ETR may further include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen), but embodiments are not limited thereto.

The second electrode EL2 may be provided onto the electron transport region ETR. The second electrode EL2 may be a common electrode. The second electrode EL2 may be a cathode or an anode, but embodiments are not limited thereto. For example, the first electrode EL1-1, EL1-2, and EL1-3 may be an anode, and the second electrode EL2 may be a cathode. In one or more embodiments, the first electrode EL1, EL1-2, and EL1-3 may be a cathode, and the second electrode EL2 may be an anode.

The second electrode EL2 may include at least one selected from among Ag, Mg, Cu, Al, Pt, Pd, Au, Ni, Nd, Ir, Cr, Li, Ca, LiF, Mo, Ti, W, In, Sn, and Zn, a compound of two or more selected therefrom, a mixture of two or more selected therefrom, or an oxide thereof. The second electrode EL2 may be a transmissive electrode, a transflective electrode, or a reflective electrode. In case that the second electrode EL2 is the transmissive electrode, the second electrode EL2 may include a transparent metal oxide, for example, indium tin oxide (ITO), indium zinc oxide (IZO), zinc oxide (ZnO), indium tin zinc oxide (ITZO), and/or the like.

When the second electrode EL2 is the transflective electrode or reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, or a compound or mixture thereof (for example, AgMg, AgYb, or MgYb). In one or more embodiments, the second electrode EL2 may have a multi-layer structure including a reflective film or transflective film including the materials mentioned above, and a transparent conductive film including indium tin oxide (ITO), indium zinc oxide (IZO), zinc oxide (ZnO), indium tin zinc oxide (ITZO), and/or the like. For example, the second electrode EL2 may include the metal materials described above, a combination of at least two metal materials selected from among the metal materials described above, an oxide of the metal materials described above, and/or the like.

A capping layer CPL may be provided onto the second electrode EL2. The capping layer CPL may have multiple layers or a single layer. The capping layer CPL may be an organic layer or an inorganic layer. For example, if (e.g., when) the capping layer CPL includes an inorganic material, the inorganic material may include an alkali metal compound such as LiF, an alkaline earth metal compound such as MgF₂, SiON, SiNₓ, SiO_{y}, and/or the like. In one or more embodiments, if (e.g., when) the capping layer CPL includes an organic material, the organic material may contain α-NPD, NPB, TPD, m-MTDATA, Alq₃, CuPc, N4,N4,N4',N4'-tetra (biphenyl-4-yl) biphenyl-4,4'-diamine (TPD15), 4,4',4"- tris (carbazol-9-yl) triphenylamine (TCTA), and/or the like, or may contain an epoxy resin, or acrylate such as methacrylate.

Hereinafter, with reference to examples and comparative examples, a light-emitting element according to one or more embodiments of the disclosure is described in more detail. In addition, the following examples are intended to help understanding of the disclosure, and the scope of the disclosure is not limited thereto.

### (1) Manufacturing Light-Emitting Element

For each of light-emitting elements according to examples and comparative example, a glass substrate (a product of Corning), including an ITO electrode of about 90 nm as an anode, was cut into a size of about 50 mm x about 50 mm x about 0.7 mm, and cleansed ultrasonically using isopropyl alcohol and then with pure water for about 5 minutes each, then irradiated with ultraviolet rays for about 30 minutes and cleansed by exposure to ozone, and then mounted on a vacuum deposition device.

TAPC:NDP9 was deposited on upper part of the anode to form a hole injection layer with a thickness of about 5 nm, then TAPC was deposited on upper part of the hole injection layer to form a hole transport layer with a thickness of about 40 nm, and then TCTA was deposited on upper part of the hole transport layer to form a buffer layer with a thickness of about 10 nm.

Thereafter, α-NPD as a first host and M-a27 as a first dopant were co-deposited in a weight ratio of about 5:5 to form a first emission layer with a thickness of about 20 nm, TCTA as a second host and M-a26 as a second dopant were co-deposited on upper part of the first emission layer in a weight ratio of about 5:5 to form a second emission layer with a thickness of about 3 nm, a host compound, in which H11 or H12 as a hole-transporting host and ETH87 as an electron-transporting host were mixed at about 1:1, and AD-45 as a phosphorescent dopant were co-deposited on upper part of the second emission layer in a weight ratio according to Table 1 to form an intermediate layer with a thickness of about 3 nm, and spiro-DPVBi was deposited on upper part of the intermediate layer to form a third emission layer with a thickness of about 10 nm.

Thereafter, ETH87 was deposited on the upper part of the third emission layer to form a hole-blocking layer with a thickness of about 5 nm. Thereafter, an aromatic compound (product name: "NET5", manufactured by Novaled) was deposited on upper part of the hole-blocking layer to form an electron transport layer with a thickness of about 10 nm, and then an aromatic compound (product name: "NET5", manufactured by Novaled) and an aromatic compound (product name: "NDN1", manufactured by Novaled) were co-deposited on upper part of the electron transport layer in a weight ratio of about 5:5 to form an electron injection layer with a thickness of about 40 nm.

Then, Al was deposited on the upper part of the electron injection layer to form a cathode with a thickness of about 100 nm, and a light-emitting element was manufactured therefrom. Each layer was formed by a vacuum deposition method.

The compounds used for the manufacturing of the light-emitting elements according to the examples and comparative example were listed. The following materials were used in the manufacturing of the elements by sublimating and refining commercial products.

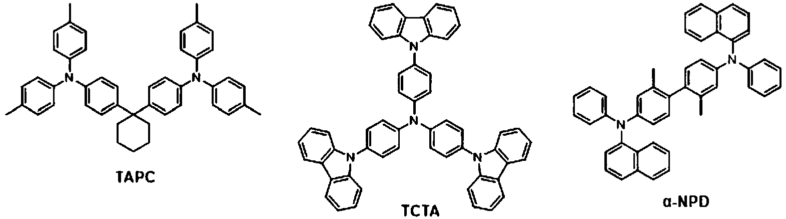

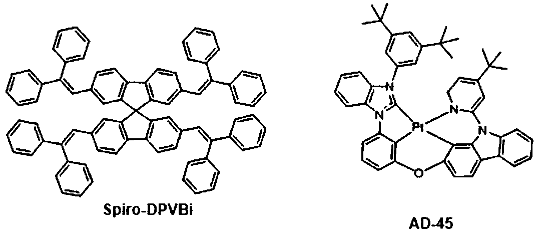

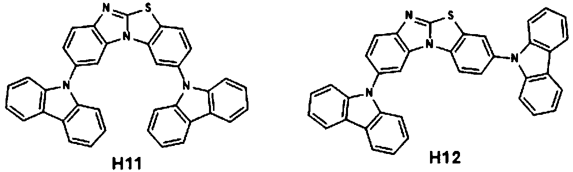

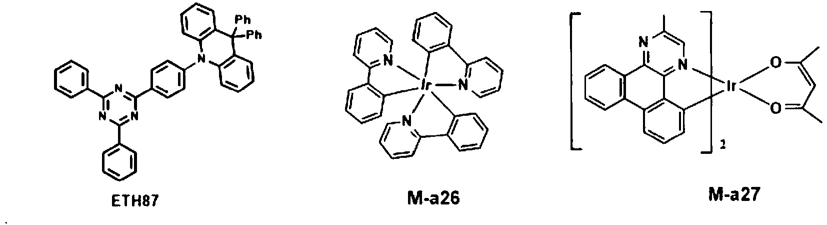

### (2) Evaluation on Characteristics of Light-Emitting Element

Element efficiency and element lifespan of the light-emitting element were evaluated. Evaluation results on the light-emitting elements according to Examples 1 to 6 and Comparative Example 1 were listed on Table 1. In order to evaluate the characteristics of the light-emitting elements, manufactured according to Examples 1 to 6 and Comparative Example 1 above, a current density (mA/cm²) at a driving voltage of about 7.45 V, and an emission efficiency (Cd/A) were measured using a Keithley MU 236, mounted on an IVL equipment, and a luminance meter PR650, quantum yield (%) was calculated through the measured luminance, and a power efficiency (Im/W) was obtained by using the values calculated through the IVL equipment, and the results were listed on Table 1.

**Table 1**

| | Intermediate layer | | Current density (mA/cm² ) | Emission efficienc y (cd/A) | Quantu m yield (%) | Power efficien cy (Im/W) |
|---|---|---|---|---|---|---|
| | Hole-transporting host/ electron-transporting host | Phosphoresce density dopant (wt%) | | | | |
| Example 1 | H11/ ETH87 | AD-45 (1%) | 90.42 | 2.36 | 4.82 | 0.80 |
| Example 2 | H11/ ETH87 | AD-45 (2%) | 92.54 | 2.54 | 6.82 | 0.85 |
| Example 3 | H11/ ETH87 | AD-45 (3%) | 92.55 | 2.42 | 5.82 | 0.81 |
| Example 4 | H12/ ETH87 | AD-45 (1%) | 90.42 | 3.21 | 6.93 | 0.95 |
| Example 5 | H12/ ETH87 | AD-45 (2%) | 92.54 | 3.55 | 8.97 | 0.99 |
| Example 6 | H12/ ETH87 | AD-45 (3%) | 92.55 | 3.21 | 7.96 | 0.92 |
| Comparat ive Example 1 | H11/ ETH87 | - | 86.74 | 1.16 | 2.68 | 0.51 |

Referring to the results on Table 1, by including an intermediate layer, and including a phosphorescent dopant in the intermediate layer, the light-emitting element according to one or more embodiments of the disclosure had high current density and high emission efficiency characteristics, and had increased quantum yield and power efficiency, compared to those of the comparative example. The light-emitting element according to one or more embodiments and an electronic apparatus including the same may have a structure of first to third emission layers stacked in sequence, and the third emission layer may include an intermediate layer of a phosphorescent emission layer and a third emission layer of a fluorescent emission layer, thereby improving emission efficiency and reliability.

Research has shown that fluorescent emission efficiency is relatively higher than phosphorescent emission efficiency in case of a field of blue color light-emitting materials. In the light-emitting element structure including all of red color, green color, and blue color emission layers, a typical technical trend is that, while the phosphorescent emission layer is used for the red color or green color emission layer, the fluorescent emission layer is used for the blue color emission layer. However, in case of using the phosphorescent emission layer for the red color or green color emission layer, triplets may jump into the adjacent blue color fluorescent emission layer to cause exciton quenching problems. However, because the light-emitting element according to one or more embodiments of the disclosure includes an intermediate layer between the first and second emission layers and the third emission layer, despite the fluorescent emission layer being included as the third emission layer, the exciton quenching problems may be solved and at the same time, emission efficiency may be improved. Because the light-emitting element according to one or more embodiments of the disclosure includes an intermediate layer containing a hole-transporting host, an electron-transporting host, and a phosphorescent dopant in the middle, the exciton quenching problem may be solved. In addition, because the intermediate layer containing the phosphorescent dopant is included, residual triplets coming from the red color or green color emission layer may be used for the phosphorescent emission, thereby improving the emission efficiency.
To put it another way, research has shown that fluorescent emission efficiency is generally higher than phosphorescent emission efficiency for blue light-emitting materials. In light-emitting elements that include red, green, and blue emission layers, a common technical approach is to use phosphorescent emission layers for the red and green regions and a fluorescent emission layer for the blue region. However, when phosphorescent layers are used for red or green and a fluorescent layer for blue, triplet excitons may migrate into the adjacent blue fluorescent layer, causing exciton quenching and reducing overall efficiency. In one or more embodiments of the present disclosure, an intermediate layer is provided between the second emission layer and the third emission layer. This intermediate layer contains a hole-transporting host, an electron-transporting host, and a phosphorescent dopant. By including this intermediate layer, exciton quenching is mitigated, and residual triplets from the red or green phosphorescent layers can be harvested for phosphorescent emission, thereby improving efficiency and device reliability. That is, the intermediate layer acts as an exciton-management region that both blocks triplet transfer to the blue fluorescent layer and converts residual triplets into useful light emission. This configuration enables high luminance and power efficiency while maintaining the advantages of fluorescent blue emission, such as longer operational lifetime.

A light-emitting element according to one or more embodiments and an electronic apparatus including the same may include an intermediate layer and a third emission layer, thereby exhibiting excellent or suitable efficiency in emitting white color light. For example, the examples and comparative data described confirm that the described architecture-including first and second phosphorescent emission layers, an intermediate layer including a hole-transporting host, an electron-transporting host, and a phosphorescent dopant, and a third fluorescent emission layer-provides measurable improvements in current density, emission efficiency, quantum yield, and power efficiency relative to comparable structures lacking the intermediate layer. These results demonstrate that the intermediate layer not only mitigates exciton quenching between phosphorescent and fluorescent regions but also enables utilization of residual triplet excitons to enhance overall performance. Thus, the disclosed embodiments achieve high luminance, extended operational lifetime, and reduced power consumption in light-emitting elements and electronic apparatuses incorporating such elements.

The description above has been made with reference to one or more embodiments of the present invention, but those skilled or of ordinary skill in the art may understand that one or more suitable modifications and changes may be made to the present invention insofar as such modifications and changes do not depart from the technical scope of the present invention set forth in the claims to be described later.

The utilization of "may" when describing embodiments of the present invention refers to "one or more embodiments of the present disclosure."

In the context of the present application and unless otherwise defined, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The light-emitting element, the display apparatus/device, the electronic apparatus/device, the manufacturing apparatuses thereof, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In the present invention, each suitable feature of the various embodiments of the invention may be combined or combined with each other, partially or entirely, and may be technically interlocked and operated in various suitable ways, and each embodiment may be implemented independently of each other or in conjunction with each other in any suitable manner unless otherwise stated or implied.

## Claims

1. A light-emitting element (ED-2) comprising:
a first electrode (EL-1);
a light-emitting unit (EP) on the first electrode (EL-1); and
a second electrode (EL-2) on the light-emitting unit (EP),
wherein the light-emitting unit (EP) comprises a first emission layer (EML1) configured to generate light with a first wavelength, a second emission layer (EML2) configured to generate light with a second wavelength different from the first wavelength and on the first emission layer (EML1), an intermediate layer (IL) on the second emission layer (EML2) and comprising a first compound, and a third emission layer (EML3) configured to generate light with a third wavelength different from the first and second wavelengths, arranged on the intermediate layer (IL), and comprising a second compound, and
wherein the first compound comprises a phosphorescent material, and the second compound comprises a fluorescent material.

2. The light-emitting element (ED-2) of claim 1, wherein the second emission layer (EML2) is directly on the first emission layer (EML1), the intermediate layer (IL) is directly on the second emission layer (EML2), and the third emission layer (EML3) is directly on the intermediate layer (IL).

3. The light-emitting element (ED-2) of claim 1 or 2, wherein the light with the first wavelength is red color light, the light with the second wavelength is green color light, and the light with the third wavelength is blue color light.

4. The light-emitting element (ED-2) of any one of the preceding claims, wherein the first compound comprises a hole-transporting host, an electron-transporting host, and a phosphorescent dopant.

5. The light-emitting element (ED-2) of claim 4, wherein the phosphorescent dopant is represented by Formula 1: 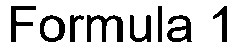 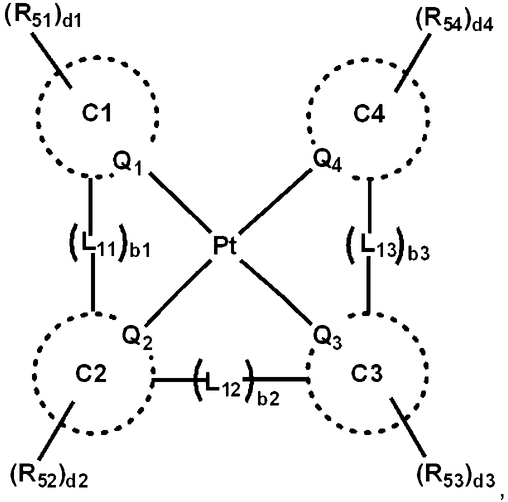 and
wherein, in Formula 1,
Q₁ to Q₄ are each independently C or N,
C1 to C4 are each independently a substituted or unsubstituted hydrocarbon ring having 5 to 30 ring-forming carbon atoms, or a substituted or unsubstituted heterocycle having 2 to 30 ring-forming carbon atoms,
L₁₁ to L₁₃ are each independently a direct linkage, 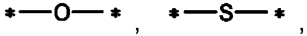 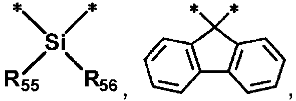 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms,
b1 to b3 are each independently 0 or 1,
R₅₁ to R₅₆ are each independently hydrogen, deuterium, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, or optionally bonded to an adjacent group to form a ring, and
d1 to d4 are each independently an integer of 0 to 4,
wherein the term "substituted" refers to the replacement on at least one hydrogen by a substituent selected from among the group consisting of deuterium, a halogen, a cyano group, nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group.

6. The light-emitting element (ED-2) of claim 4 or 5, wherein the hole-transporting host comprises a compound represented by Formula H1: 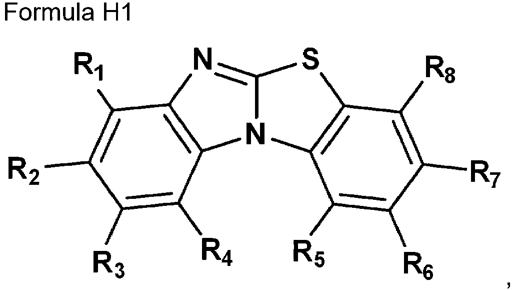 and
wherein, in Formula H1,
R₁ to R₈ are each independently hydrogen, deuterium, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or optionally bonded to an adjacent group to form a ring,
wherein the term "substituted" refers to the replacement on at least one hydrogen by a substituent selected from among the group consisting of deuterium, a halogen, a cyano group, nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group.

7. The light-emitting element (ED-2) of any one of claims 4 to 6, wherein the electron-transporting host comprises a compound represented by Formula ET-1: 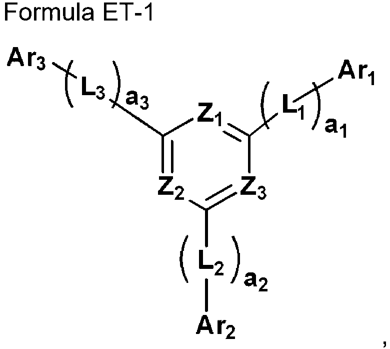 and
wherein, in Formula ET-1,
at least one among Z₁ to Z₃ is N, and the rest are CR₉,
R₉ is hydrogen, deuterium, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
a₁ to a₃ are each independently an integer of 0 to 10,
L₁ to L₃ are each independently a direct linkage, a substituted or unsubstituted arylene group having 6 to 30 ring-forming carbon atoms, or a substituted or unsubstituted heteroarylene group having 2 to 30 ring-forming carbon atoms,
when each of a₁ to a₃ is an integer of 2 or greater, L₂ to L₃ are each independently a substituted or unsubstituted arylene group having 6 to 30 ring-forming carbon atoms, or a substituted or unsubstituted heteroarylene group having 2 to 30 ring-forming carbon atoms, and
Ar₁ to Ar₃ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms,
wherein the term "substituted" refers to the replacement on at least one hydrogen by a substituent selected from among the group consisting of deuterium, a halogen, a cyano group, nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group.

8. The light-emitting element (ED-2) of any one of claims 4 to 7, wherein a weight percentage of the phosphorescent dopant relative to a total weight of the intermediate layer is 0.1% or greater and 5.0% or less.

9. The light-emitting element (ED-2) of any one of the preceding claims, wherein the second compound comprises a spiro compound.

10. The light-emitting element (ED-2) of any one of the preceding claims, wherein each of the first emission layer (EML1) and the second emission layer (EML2) is a phosphorescent emission layer.

11. The light-emitting element (ED-2) of any one of the preceding claims,
wherein the first emission layer (EML1) comprises a first host and a first dopant,
wherein the second emission layer (EML2) comprises a second host and a second dopant,
wherein each of the first dopant and the second dopant, independently, comprises a compound represented by Formula D: 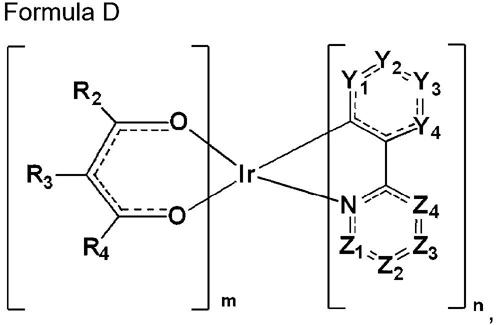 and
wherein, in Formula D,
Y₁ to Y₄ and Z₁ to Z₄ are each independently CR₁ or N,
R₁ to R₄ are each independently hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or optionally bonded to an adjacent group to form a ring,
m is 0 or 1, and
n is 2 or 3,
wherein the term "substituted" refers to the replacement on at least one hydrogen by a substituent selected from among the group consisting of deuterium, a halogen, a cyano group, nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group.

12. The light-emitting element (ED-2) of any one of the preceding claims, further comprising a hole transport region (HTR) between the first electrode (EL1) and the light-emitting unit (EP), and an electron transport region (ETR) between the second electrode (EL2) and the light-emitting unit (EP).

13. The light-emitting element (ED-2) of any one of the preceding claims,
wherein the first emission layer (EML1) has a first thickness of 10 nm or greater and 30 nm or less, and
wherein the second emission layer (EML2) has a second thickness of 1 nm or greater and 10 nm or less.

14. The light-emitting element (ED-2) of any one of the preceding claims, wherein a thickness of the intermediate layer (IL) is less than a thickness of the third emission layer (EML3).

15. The light-emitting element (ED-2) of claim 14,
wherein the thickness of the interlayer (IL) is 1 nm or greater and 10 nm or less, and the thickness of the third emission layer (EML3) is 5 nm or greater and 20 nm or less.
